# EUROPEAN PATENT APPLICATION

(11) **EP 4 117 044 A1**
(43) Date of publication of application: **11.01.2023**
(21) Application number: 20922833.7
(22) Date of filing: 27.11.2020
(51) Int. Cl.: H01L 31/0368, H01L 31/0376, H01L 31/0687, H01L 31/072, H01L 31/02, H01L 31/0224, H01L 31/18

(54) **SOLAR CELL AND METHOD OF FABRICATING SAME**

(30) Priority: 04.03.2020 KR 20200027368
(71) Applicant: LG Electronics, Inc., Yeongdeungpo-gu Seoul 07336 (KR)
(72) Inventor: LEE, Kyoungsoo, Seoul 06772 (KR); LEE, Giwon, Seoul 06772 (KR); SHIM, Goohwan, Seoul 06772 (KR)
(74) Representative: DREISS Patentanwälte PartG mbB
(86) International application number: PCT/KR2020/017168
(87) International publication number: WO 2021/177552

(57) **Abstract**

A solar cell according to the present embodiment may have a tandem structure comprising a photovoltaic part, wherein the photovoltaic part comprises: a first photovoltaic part comprising: a photovoltaic layer composed of a perovskite compound; and a second photovoltaic part comprising a semiconductor substrate. Here, in the second photovoltaic part, a first semiconductor layer and a second semiconductor layer, which are formed separately from the semiconductor substrate on one side or the other side of the semiconductor substrate, may have different structures from each other.

## Description

### [Technical Field]

The present disclosure relates to a solar cell and a method for fabricating the same, and more particularly, to a solar cell having an improved structure and a method of fabricating the same.

### [Background Art]

A solar cell including a semiconductor substrate has excellent efficiency and is widely used. However, the solar cell including the semiconductor substrate also have certain limitations in improving efficiency, and as a result, solar cells having various structures capable of improving photoelectric conversion efficiency have been proposed.

For example, a solar cell in which a photovoltaic part containing a perovskite compound that absorbs light of a short wavelength and performs photoelectric conversion using a short wavelength has been proposed. In the solar cell in which the photovoltaic part contains such a perovskite compound, as in Korean Patent Application Laid-Open No. 10-2016-0040925, another photovoltaic part having a different structure or material from the photovoltaic part containing the perovskite compound is stacked to achieve excellent efficiency.

In the solar cell having such a structure, it is very important that a plurality of photovoltaic parts stacked on each other have excellent connection characteristics in order to improve efficiency. In this case, in order to improve the efficiency of the solar cell, at least one photovoltaic part may include a passivation layer for improving passivation characteristics, and the passivation layer may include an insulating layer composed of an insulating material. When such an insulating layer is positioned between a plurality of photovoltaic parts, the passivation layer becomes a big obstacle to movement of carriers, so it is difficult to improve the efficiency of the solar cell.

### [Disclosure]

### [Technical Problem]

The present embodiment is intended to provide a solar cell having excellent efficiency and a method of fabricating the same. In particular, the present embodiment provides a solar cell having a tandem structure including a photovoltaic part containing a perovskite compound and another photovoltaic part having a different material or structure and having excellent efficiency, and a method of fabricating the same.

More specifically, the present embodiment is intended to provide a solar cell having excellent efficiency by facilitating movement of carriers while improving passivation characteristics in a tandem structure including a plurality of photovoltaic parts, and a method of fabricating the same.

In addition, the present embodiment is intended to provide a solar cell that is fabricated by a simple process to improve productivity, and a method of fabricating the same.

### [Technical Solution]

According to the present embodiment, a solar cell may have a tandem structure including a photovoltaic part that includes a first photovoltaic part including a photovoltaic layer composed of a perovskite compound and a second photovoltaic part including a semiconductor substrate. Here, in the second photovoltaic part, a first semiconductor layer and a second semiconductor layer, which are formed separately from the semiconductor substrate on one side or the other side of the semiconductor substrate, may have different structures from each other. Thereby, it is possible to improve passivation characteristics and carrier movement characteristics in the tandem structure, and to simplify a fabricating process. The solar cell according to the present embodiment may further include a first electrode electrically connected to the photovoltaic part on one side of the photovoltaic part and a second electrode electrically connected to the photovoltaic part on the other side of the photovoltaic part.

More specifically, the first semiconductor layer positioned on a front side of the semiconductor substrate may include an amorphous portion, and the second semiconductor layer positioned on a rear side of the semiconductor substrate may include a polycrystalline portion. Alternatively, in the second photovoltaic part, the first semiconductor layer positioned adjacent to the first photovoltaic part may include an amorphous portion, and in the second photovoltaic part, the second semiconductor layer positioned on a surface opposite to the first photovoltaic part may include a polycrystalline portion.

Here, a thickness of the second semiconductor layer including the polycrystalline portion may be greater than that of the first semiconductor layer including the amorphous portion, and a hydrogen content of the first semiconductor layer including the amorphous portion may be greater than that of the second semiconductor layer including the polycrystalline portion.

The solar cell according to the present embodiment may further include a first intermediate film positioned between the semiconductor substrate and the first semiconductor layer, and a second intermediate film positioned between the semiconductor substrate and a second conductive region. Since the first semiconductor layer and the second semiconductor layer have different crystal structures, materials or thicknesses of the first intermediate film and the second intermediate film may be different from each other, so a junction structure of the first semiconductor layer and the second semiconductor layer may be different from each other.

For example, the semiconductor substrate and the first semiconductor layer may have a hetero-junction structure having different crystal structures with a first intermediate film composed of a semiconductor material therebetween, and the semiconductor substrate and the second semiconductor layer may have an insulating junction structure or a tunnel-junction structure in which the semiconductor substrate and the second semiconductor layer are bonded to each other with the second intermediate film composed of an insulating material therebetween. Alternatively, the first intermediate film may contain a semiconductor material, and the second intermediate film may contain an insulating material. For example, the first intermediate film may contain intrinsic amorphous silicon, and the second intermediate film may contain silicon oxide.

Here, a thickness of the second intermediate film may be smaller than that of the first intermediate film, and a hydrogen content of the first intermediate film may be greater than that of the second intermediate film.

Since the first semiconductor layer and the second semiconductor layer have different crystal structures, a stacked structure of the first electrode positioned on the first photovoltaic part and the second electrode included in the second photovoltaic part and positioned on the second semiconductor layer having the polycrystalline portion may be different from each other.

For example, the first electrode may include a first electrode layer that is formed on the first photovoltaic part and contains a transparent conductive material, and a second electrode layer that is formed on the first electrode layer and contains a metal. The second electrode layer may include a metal electrode layer that is formed on the second electrode layer and contains a metal.

In addition, the solar cell according to the present embodiment may include at least one of an anti-reflection film formed on the first electrode layer and an optical film formed on the second semiconductor layer.

According to the present embodiment, a method of fabricating a solar cell may include forming a second photovoltaic part, forming a first photovoltaic part, and forming an electrode. In the forming of the second photovoltaic part, the second photovoltaic part including a semiconductor substrate, a first semiconductor layer that is formed separately from the semiconductor substrate on one side of the semiconductor substrate, and a second semiconductor layer that is formed separately from the semiconductor substrate on the other side of the semiconductor substrate and has a crystal structure different from that of the first semiconductor layer is formed. In the forming of the first photovoltaic part, a first photovoltaic part including a photovoltaic layer composed of a perovskite compound is formed on the first semiconductor layer. In the forming of the electrode, a first electrode electrically connected to the first photovoltaic part may be formed on one side of the first photovoltaic part and a second electrode electrically connected to the second photovoltaic part may be formed on the other side of the second photovoltaic part.

Here, the forming of the second photovoltaic part may include forming a second portion including the second semiconductor layer including a polycrystalline portion on the other side of the semiconductor substrate, and forming a first portion including the first semiconductor layer including an amorphous portion on the one side of the semiconductor substrate.

In this case, the method of fabricating a solar cell may further include injecting hydrogen into the second semiconductor layer between the forming of the second portion and the forming of the first portion. In the forming of the first portion, a process of injecting hydrogen into the first semiconductor layer may be performed together.

Since the first semiconductor layer and the second semiconductor layer have different crystal structures, the first semiconductor layer and the second semiconductor layer may be formed by different processes or different process conditions. For example, a temperature of the process of forming the first semiconductor layer may be lower than that of the process of forming the second semiconductor layer, and a pressure of the process of forming the first semiconductor layer is higher than that of the process of forming the second semiconductor layer. In the forming of the second portion, after forming a second portion on both sides of the semiconductor substrate by a double-sided deposition process, the second portion formed on one side may be removed. In the forming of the first portion, the first portion may be formed on one side of the semiconductor substrate by a single-sided deposition process.

The forming of the second portion may further include a process of forming a second intermediate film before a process of forming the second semiconductor layer, and the forming of the first portion may further include a process of forming a first intermediate film before a process of forming the first semiconductor layer. In this case, the process of forming the second intermediate film and the forming of the second semiconductor layer may be formed by a continuous process, and the process of forming the first intermediate film and the process of forming the first semiconductor layer may be formed by the continuous process.

### [Advantageous Effects]

According to the present embodiment, in a tandem structure including a first photovoltaic part containing a perovskite compound and a second photovoltaic part including a semiconductor substrate, it is possible to improve efficiency and productivity by making crystal structures of a first semiconductor layer and a second semiconductor layer of the second photovoltaic part different. That is, a first semiconductor layer includes a hydrogenated amorphous portion containing hydrogen to improve passivation characteristics, and improve matchability with a first photovoltaic part containing a perovskite compound to improve carrier movement characteristics. In addition, a second semiconductor layer may include a polycrystalline portion having excellent carrier mobility to improve carrier movement characteristics, reduce material costs of a second electrode, and simplify a fabricating process.

According to the present embodiment, it is possible to improve productivity by forming a solar cell having a tandem structure having excellent efficiency through a simple fabricating process. In this case, it is possible to effectively prevent characteristics of a first semiconductor layer containing an amorphous part or a first photovoltaic part containing a perovskite compound from deteriorating by maintaining a process temperature in an electrode forming step or the like performed after the first photovoltaic part forming step of forming the first photovoltaic part at a low temperature.

### [Description of Drawings]

FIG. 1 is a cross-sectional view schematically illustrating a solar cell according to an embodiment of the present disclosure.
FIG. 2 is a front plan view illustrating a front side of a solar cell illustrated in FIG. 1.another embodiment of the present disclosure.
FIG. 3 is a diagram schematically illustrating an example of conductivity types and roles of a plurality of layers included in a photovoltaic part of a solar cell according to an embodiment of the present disclosure.
FIG. 4 is an energy band diagram schematically illustrating energy bands of the solar cell illustrated in FIG. 3 and photovoltaic parts of solar cells according to Comparative Examples 1 and 2.
FIG. 5 is a diagram schematically illustrating another example of the conductivity types and roles of the plurality of layers included in the solar cell according to the embodiment of the present disclosure.
FIG. 6 is a diagram schematically illustrating another example of the conductivity types and roles of the plurality of layers included in the solar cell according to the embodiment of the present disclosure.
FIG. 7 is a diagram schematically illustrating another example of the conductivity types and roles of the plurality of layers included in the solar cell according to the embodiment of the present disclosure.
FIG. 8 is a flowchart illustrating a method of fabricating a solar cell according to an embodiment in the present disclosure.
FIGS. 9A to 9F are cross-sectional views illustrating a method of fabricating a solar cell according to an embodiment of the present disclosure.
FIG. 10 is a cross-sectional view schematically illustrating a solar cell according to another embodiment of the present disclosure.
FIG. 11 is a cross-sectional view schematically illustrating a solar cell according to another embodiment of the present disclosure.
FIG. 12 is a plan view illustrating a solar cell according to another embodiment of the present disclosure.

### [Mode for Disclosure]

Hereinafter, embodiments of the present disclosure will be described in detail with reference to the accompanying drawings. However, it goes without saying that the present disclosure is not limited to these embodiments and may be modified in various forms.

In the drawings, in order to clearly and briefly describe the present disclosure, the illustration of parts irrelevant to the description is omitted, and the same reference numerals are used for the same or extremely similar parts throughout the specification. In addition, in the drawings, a thickness, a width, etc., are enlarged or reduced in order to make the description more clear, and the thickness, the width, or the like of the present disclosure are not limited to those illustrated in the drawings.

When a certain part "includes" another part throughout the specification, other parts are not excluded unless otherwise stated, and other parts may be further included. In addition, when parts such as a layer, a film, a region, or a plate is referred to as being "on" another part, it may be "directly on" another part or may have another part present therebetween. In addition, when a part of a layer, film, region, plate, etc., is "directly on" another part, it means that no other part is positioned therebetween.

Hereinafter, a solar cell and a method of fabricating the same according to an embodiment of the present disclosure will be described in detail with reference to the accompanying drawings. In the present specification, expressions such as "first" and "second" are used to distinguish each other, and the present disclosure is not limited thereto.

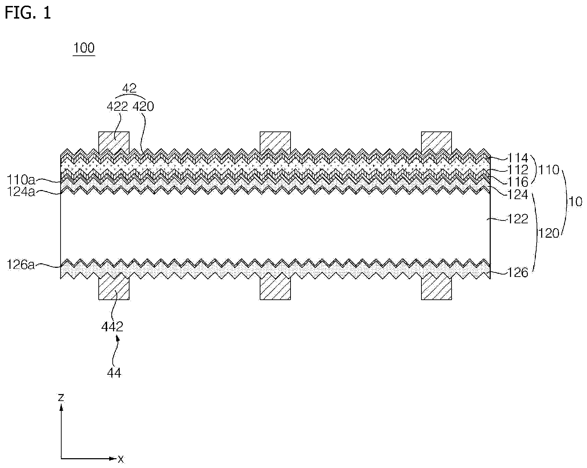

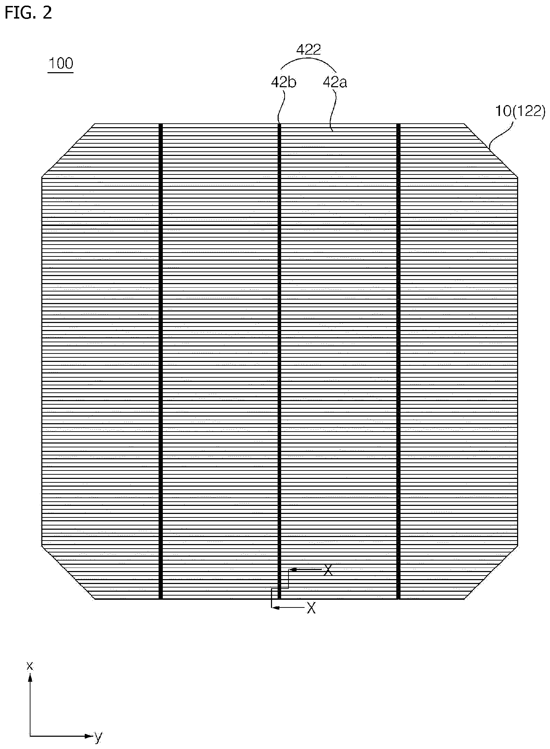

FIG. 1 is a cross-sectional view schematically illustrating a solar cell according to an embodiment of the present disclosure, and FIG. 2 is a front plan view illustrating a front side of a solar cell illustrated in FIG. 1.another embodiment of the present disclosure. For clear understanding, an illustration of a first electrode layer of a first electrode is omitted in FIG. 2, and a second electrode layer is mainly illustrated.

Referring to FIG. 1, a solar cell 100 according to the present embodiment may include a photovoltaic part 10 including first and second photovoltaic parts 110 and 120. That is, the photovoltaic part 10 may have a tandem structure including a plurality of photovoltaic parts 110 and 120 stacked on each other. In this case, in the second photovoltaic part 120, a first semiconductor layer 124 having a first conductivity type and a second semiconductor layer 126 having a second conductivity type have different crystal structures.

More specifically, the photovoltaic part 10 includes a first photovoltaic part 110 that includes a photovoltaic layer 112 composed of a perovskite compound, and a second photovoltaic part 120 that includes a semiconductor substrate (e.g., a silicon substrate) 122. In this case, the second photovoltaic part 120 may include a semiconductor substrate 122, a first semiconductor layer 124 that is formed separately from the semiconductor substrate 122 on one side (e.g., a front side) of the semiconductor substrate 122, and a second semiconductor layer 126 that is formed separately from the semiconductor substrate 10 on the other side (e.g., a rear side) of the semiconductor substrate 122 and has a crystal structure different from that of the first semiconductor layer 124. In addition, the solar cell 100 may include a first electrode 42 that is electrically connected to the photovoltaic part 10 on one side (e.g., a front side) of the photovoltaic part 10, and a second electrode 44 that is electrically connected to the photovoltaic part 10 on the other side (e.g., a rear side) of the photovoltaic part 10. A detailed description thereof will be provided below.

In the present embodiment, in the second photovoltaic part 120, the semiconductor substrate 122 may be composed of a crystalline semiconductor (e.g., single crystal or polycrystalline semiconductor, for example, single crystal or polycrystalline silicon) containing a single semiconductor material (e.g., a group 4 element). Then, since the second photovoltaic part 120 is based on the semiconductor substrate 122 with high crystallinity and fewer defects, the second photovoltaic part 120 may have excellent electrical characteristics. In particular, the semiconductor substrate 122 is composed of a single crystal semiconductor, for example, single crystal silicon, and thus, may have better electrical characteristics. As such, the second photovoltaic part 120 may have a crystalline silicon solar cell structure including the crystalline semiconductor substrate 122.

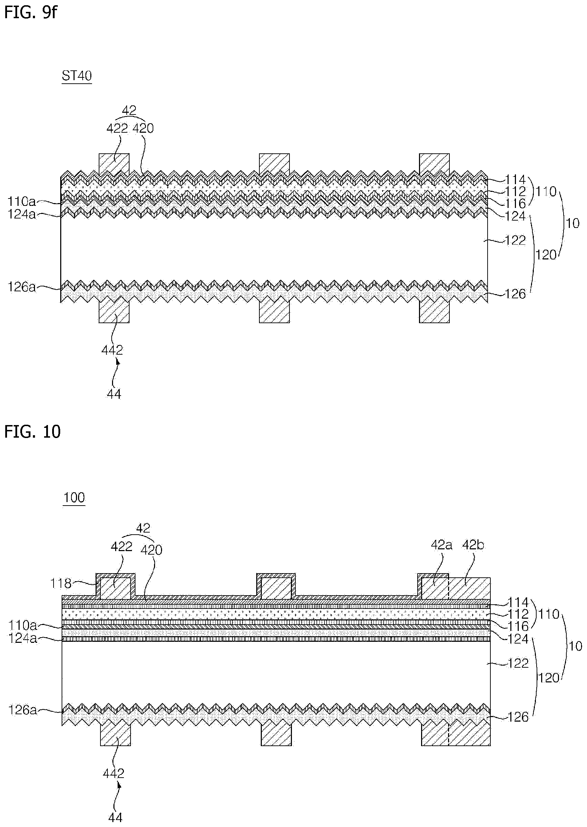

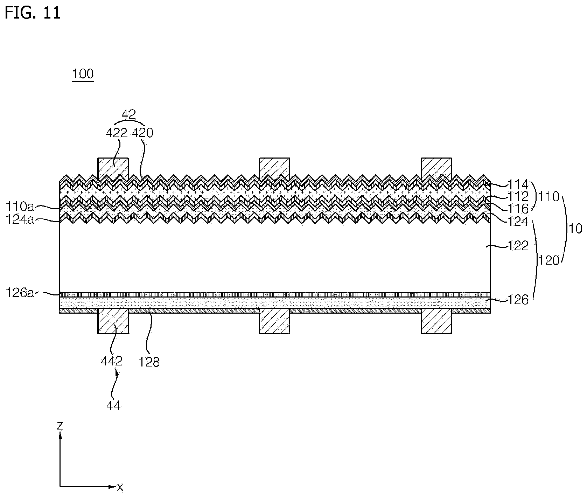

The front side and/or the rear side of the semiconductor substrate 122 may be textured to have an uneven or anti-reflection structure. The uneven or anti-reflection structure may have, for example, a pyramid shape in which a surface constituting the front side and/or the rear side of the semiconductor substrate 122 is configured as a (111) surface of the semiconductor substrate 122 and has an irregular size. Thereby, when surface roughness is relatively large, reflectance of light may be lowered. In the drawings, it is exemplified that an anti-reflection effect is maximized by forming the uneven or anti-reflection structure on the front and rear sides of the semiconductor substrate 122, respectively. However, the present disclosure is not limited thereto, and the uneven or anti-reflection structure may be formed on at least one of the front side and the rear side, or the uneven or anti-reflection structure may not be provided on both the front side and the rear side. Some of these other embodiments will be described later in more detail with reference to FIGS. 10 and 11. In addition to this, various modifications are possible.

In the present embodiment, the semiconductor substrate 122 may be configured to include a base region having a first or second conductivity type by being doped with a first or second conductive dopant having a doping concentration lower than that of the first or second semiconductor layers 124 and 126. That is, the semiconductor substrate 122 may include only the base region without a doping region formed by additionally doping the base region with a dopant.

In the present embodiment, the first semiconductor layer 124 positioned on one side (e.g., a front side) of the semiconductor substrate 122 may be a semiconductor layer having a first conductivity type, including the first conductive dopant. The second semiconductor layer 126 positioned on the other side (e.g., a rear side) of the semiconductor substrate 122 may be a semiconductor layer having a second conductivity type, including the second conductive dopant.

For example, as a p-type dopant among the first and second conductive dopants, a group 3 element such as boron (B), aluminum (Al), gallium (Ga), and indium (In) may be used, and as an n-type dopant, a group 5 element such as phosphorus (P), arsenic (As), bismuth (Bi), or antimony (Sb) may be used. The first or second conductive dopant of the semiconductor substrate 122 and the first or second conductive dopant of the first or second semiconductor layers 124 and 126 may be the same material as or different materials from each other.

Roles of the first and second semiconductor layers 124 and 126 and materials, roles, and the like of the first and second transport layers 114 and 116 included in the first photovoltaic part 110 may be changed according to the conductivity type of the semiconductor substrate 122 and the first and second semiconductor layers 124 and 126. This will be described in more detail after the first photovoltaic part 110 and the first and second electrodes 42 and 44 are described.

A first intermediate film 124a may be provided between the front side of the semiconductor substrate 122 and the first semiconductor layer 124, and a second intermediate film 126a may be provided between the rear side of the semiconductor substrate 122 and the second semiconductor layer 126. For example, the first intermediate film 124a may be formed in contact with the front side of the semiconductor substrate 122, the first semiconductor layer 124 may be formed in contact with the first intermediate film 124a, the second intermediate film 126a may be formed in contact with the rear side of the semiconductor substrate 122, and the second semiconductor layer 126 may be formed in contact with the second intermediate film 126a. As a result, it is possible to simplify a carrier movement path by simplifying the structure, and the present disclosure is not limited thereto, and various modifications are possible.

In the present embodiment, the first and second semiconductor layers 124 and 126 and/or the first and second intermediate films 124a and 126a may be entirely formed on the front side and the rear side of the semiconductor substrate 122, respectively. As a result, the first and second semiconductor layers 124 and 126 and/or the first and second intermediate films 124a and 126a may be formed with a sufficient area without separate patterning. However, the present disclosure is not limited thereto.

In the present embodiment, it is exemplified that the first and second semiconductor layers 124 and 126 are each configured as a semiconductor layer formed separately from the semiconductor substrate 122 or the base region. As a result, the crystal structures of the first and second semiconductor layers 124 and 126 may be different from the crystal structure of the semiconductor substrate 122. Accordingly, since the semiconductor substrate 122 does not include a doping region, the semiconductor substrate may have excellent passivation characteristics, and the first and second semiconductor layers 124 and 126 may be easily formed by a simple process. In addition, it is possible to reduce costs by reducing the thickness of the semiconductor substrate 122, which has excellent characteristics and is expensive.

In addition to this, in the present embodiment, the first semiconductor layer 124 and the second semiconductor layer 126 formed separately on the semiconductor substrate 122 may have different crystal structures. In addition, the first intermediate film 124a and the second intermediate film 126b may include different materials. This will be described in more detail after the first photovoltaic part 110 and the first and second electrodes 42 and 44 are described.

A junction layer (tunnel-junction layer) 110a is positioned on one side (e.g., a front side) of the second photovoltaic part 120 or on the first semiconductor layer 124, and thus, the second photovoltaic part 120 and the first photovoltaic part 110 positioned thereon are electrically connected to each other. FIG. 1 illustrates that the junction layer 110a contacts the first semiconductor layer 124 of the second photovoltaic part 124 and the second transport layer 116 of the first photovoltaic part 110, respectively, to simplify the structure, but the present disclosure is not limited thereto. The junction layer 110a may have a thin thickness, for example, a thickness smaller than that of the first electrode layer 420 of the first electrode 42 so that tunneling of a carrier may occur smoothly.

The junction layer 110a may electrically connect the first photovoltaic part 110 and the second photovoltaic part 120, and may include a material through which light (e.g., long-wavelength light) used for the second photovoltaic part 120 may be transmitted. For example, the junction layer 110a may include at least one of various materials such as a transparent conductive material (e.g., transparent conductive oxide), a conductive carbon material, a conductive polymer, and n-type or p-type amorphous silicon. Alternatively, the junction layer 110a is formed in a structure in which silicon layers having different refractive indices are alternately stacked, so the light (e.g., short-wavelength light) used in the first photovoltaic part 110 may be reflected to the first photovoltaic part 110 and the light (e.g., long-wavelength light) used in the second photovoltaic part 120 may be transmitted and provided to the second photovoltaic part 120. However, the present disclosure is not limited thereto, and various materials may be applied as materials and structures of the junction layer 110a.

The first photovoltaic part 110 that includes the photovoltaic layer 112 containing a perovskite compound may be positioned on the junction layer 110a. More specifically, the first photovoltaic part 110 may include a photovoltaic layer (112), a first transport layer (first carrier transport layer) 114 positioned between the photovoltaic layer 112 and the first electrode 42 on the other side opposite to one side of the photovoltaic layer 112 adjacent to the second photovoltaic part 120, and a second transport layer (second carrier transport layer) 116 positioned between the junction layer 110a and the photovoltaic layer 112 on one side of the photovoltaic layer 112 adjacent to the second photovoltaic part 120.

For example, the photovoltaic layer 112 may be a photoactive layer that is excited by light composed of a perovskite compound having a perovskite structure to form carriers (electrons and holes). For example, the perovskite structure may have a chemical formula of AMX₃ (where A denotes a monovalent organic ammonium cation or metal cation; M denotes a divalent metal cation; X denotes a halogen anion). The photovoltaic layer 112 may include, as AMX₃, CH₃NH₃PbI₃, CH₃NH₃PbIₓCl₍₃₋ₓ₎, CH₃NH₃PbIₓBr₍₃₋ₓ₎, CH₃NH₃PbClₓBr₍₃₋ₓ₎, HC(NH₂)₂PbI₃, HC(NH₂)₂PbIₓCl₍₃₋ₓ₎, HC(NH₂)₂PbIₓBr₍₃₋ₓ₎, HC(NH₂)₂PbClₓBr₍₃₋ₓ₎, etc., or a compound in which A of AMX₃ is partially doped with Cs. However, the present disclosure is not limited thereto, and various materials may be used as the photovoltaic layer 112.

The second transport layer 116 positioned between the junction layer 110a and the photovoltaic layer 112 on the other side (e.g., a rear side) of the photovoltaic part 112 is a layer that extracts and transports a second carrier by a bandgap relationship with the photovoltaic layer 112, and the first transport layer 114 positioned between the photovoltaic layer 112 and the first electrode 42 on one side (e.g., a front side) of the photovoltaic layer 112 is a layer that extracts and transports a first carrier by a bandgap relationship with the photovoltaic layer 112. Here, the first carrier refers to a carrier that moves to the first semiconductor layer 124 according to the first conductivity type of the first semiconductor layer 124 and is a majority carrier for the first conductivity type. When the first semiconductor layer 124 is an n-type, the first carrier is an electron, and when the first semiconductor layer 124 is a p-type, the first carrier is a hole. The second carrier refers to a carrier that moves to the second semiconductor layer 126 according to a second conductivity type of the second semiconductor layer 126 and is a majority carrier for the second conductivity type. When the second semiconductor layer 126 is a p-type, the second carrier is a hole, and when the second semiconductor layer 126 is an n-type, the second carrier is an electron.

A layer that transports electrons among the first and second transport layers 114 and 116 may be referred to as an electron transport layer, and a layer that transports holes may be referred to as a hole transport layer. Examples of the hole transport layer may include a spiro-bifluorene compound (e.g., 2,2',7,7'-tetrakis(N,N-di-p-methoxyphenylamine)-9,9'-spirobifluorene (spiro-OMeTAD), etc.), polytriarylamine (PTAA), or a metal compound (e.g., molybdenum oxide, etc.). In addition, the electron transport layer may include fullerene (C₆₀) or a derivative thereof (e.g., phenyl-C₆₁-butyric acid methyl ester (PCBM), etc.). However, the present disclosure is not limited thereto, and the first transport layer 114 and the second transport layer 116, or the electron transport layer and the hole transport layer may include various materials capable of transporting the first or second carrier.

FIG. 1 illustrates that the second transport layer 116, the photovoltaic layer 112, and the first transport layer 114 contact each other to minimize the carrier movement path. However, the present disclosure is not limited thereto, and various modifications are possible.

The first electrode 42 may be positioned on the photovoltaic part 10 (for example, the first transport layer 114 positioned on the front side of the first photovoltaic part 110), and the second electrode may be positioned on the photovoltaic part 10 (for example, the second semiconductor layer 126 positioned on the rear side of the photovoltaic part 120).

In the present embodiment, the first electrode 42 may include a first electrode layer 420 and a second electrode layer 422 sequentially stacked on one side (e.g., a front side) of the photovoltaic part 10.rode layer 422 may have various planar shapes.

Here, the first electrode layer 420 may be entirely formed on the photovoltaic part 10 (e.g., the first transport layer 114 positioned on the front side of the first photovoltaic part 110). For example, the first electrode layer 420 may be entirely formed on the photovoltaic part 10 while being in contact with the photovoltaic part 10 (e.g., the first transport layer 114 positioned on the front side of the first photovoltaic part 110). In the present specification, entirely forming the first electrode layer 420 on the photovoltaic part 10 may include not only covering the entire photovoltaic part 10 without an empty space or an empty region, but also a case in which a portion of photovoltaic part 10 is inevitably not formed. As such, when the first electrode layer 420 is entirely formed on the first photovoltaic part 110, the first carrier may easily reach the second electrode layer 422 through the first electrode layer 420, so the resistance in the horizontal direction may be reduced.

As such, since the first electrode layer 420 is entirely formed on the photovoltaic part 10, the first electrode layer 420 may be composed of a material (transmissive material) that may transmit light. That is, the first electrode layer 420 is composed of a transparent conductive material, and thus, may easily move carriers while transmitting light. Accordingly, even when the first electrode layer 420 is entirely formed on the photovoltaic part 10, light transmission is not blocked. For example, the first electrode layer 420 may contain a transparent conductive material (e.g., a transparent conductive oxide, for example, metal-doped indium oxide, carbon nano tube (CNT)), etc. Examples of the metal-doped indium oxide include tin-doped indium oxide (ITO), tungsten-doped indium oxide (IWO), cesium-doped indium oxide (ICO), etc. However, the present disclosure is not limited thereto, and the first electrode layer 420 may contain various other materials.

In addition, a second electrode layer 422 may be formed on the first electrode layer 420. For example, the second electrode layer 422 may be formed in contact with the first electrode layer 422. The second electrode layer 422 may be composed of a material having superior electrical conductivity than that of the first electrode layer 420. Accordingly, characteristics such as carrier collection efficiency and resistance reduction by the second electrode layer 422 may be further improved. For example, the second electrode layer 422 may be composed of an opaque metal having excellent electrical conductivity or a metal having a lower transparency than the first electrode layer 420.

As such, the second electrode layer 422 may be partially formed to minimize shading loss to have a predetermined pattern because the second electrode layer 422 is opaque or has low transparency to prevent light from entering. As a result, light may be incident to a portion where the second electrode layer 422 is not formed.

For example, the second electrode layer 422 may include a plurality of finger electrodes 42a spaced apart from each other while having a constant pitch. FIG. 2 illustrates that the finger electrodes 42a are parallel to each other and parallel to a main edge of the photovoltaic part 10 (e.g., a semiconductor substrate 122), but the present disclosure is not limited thereto. In addition, the second electrode layer 422 may include a bus bar electrode 42b that is formed in a direction crossing the finger electrodes 42a and connects the finger electrodes 42a. Only one bus electrode 42b may be provided, or a plurality of bus electrodes 42b may be provided while having a pitch larger than that of the finger electrodes 42a, as illustrated in FIG. 2. In this case, a width of the bus bar electrode 42b may be greater than that of the finger electrode 42a, but the present disclosure is not limited thereto. Accordingly, the width of the bus bar electrode 42b may be equal to or smaller than that of the finger electrode 42a. However, the present disclosure is not limited thereto, and the second electrode layer 422 may have various planar shapes.

In the present embodiment, the second electrode 44 may have a different stacked structure from that of the first electrode 42. This is in consideration of the material of the first photovoltaic part 110 and the crystal structure of the second semiconductor layer 126 included in the second photovoltaic part 120, which will be described in more detail later.

For example, in the present embodiment, the second electrode 44 may include a metal electrode layer 442 positioned on the other side (e.g., a rear side) of the photovoltaic part 10. For example, the second electrode 44 is configured as a single layer of the metal electrode layer 442 in contact with the photovoltaic part 10 (more specifically, the second semiconductor layer 126), and may not further include a transparent conductive oxide layer, etc.

The metal electrode layer 442 of the second electrode 42 may be composed of a material having superior electrical conductivity than that of the first electrode layer 420 of the first electrode 42. For example, the metal electrode layer 442 of the second electrode 42 may be composed of an opaque metal having excellent electrical conductivity or a metal having a lower transparency than that of the first electrode layer 420 of the first electrode 42. As described above, the metal electrode layer 442 may be partially formed on the photovoltaic part 10 to have a predetermined pattern. Accordingly, in the double-sided light receiving structure, light may be incident to a portion where the metal electrode layer 442 is not formed.

For example, the metal electrode layer 442 includes a plurality of finger electrodes spaced apart from each other while each having a constant pitch, and may further include a bus bar electrode that is formed in a direction crossing the finger electrodes to connect the finger electrodes. Except that the metal electrode layer 442 is positioned on the other side of the photovoltaic part 10, the description of the finger electrode 42a and the bus bar electrode 42b included in the second electrode layer 422 of the first electrode 42 may be applied to the finger electrode and the bus bar electrode of the metal electrode layer 442. In this case, the widths, pitches, and the like of the finger electrode 42 and the bus bar electrode 42b of the first electrode 42 may have the same value as or different values from those of the finger electrode and the bus bar electrode of the second electrode 44. In addition, the second electrode layer 422 of the first electrode 42 and the metal electrode layer 442 of the second electrode 44 may have the same or different materials, compositions, shapes, or thicknesses.

According to the present embodiment, the metal electrode layer 442 containing an opaque metal or a metal has a predetermined pattern in the electrode layer 442 of the first and second electrodes 42 and 44 in the solar cell 100, and thus, has a bi-facial structure in which light may be incident to the front and rear sides of the photovoltaic parts 110 and 120. Accordingly, the amount of light used in the solar cell 100 may be increased, so it is possible to contribute to the improvement in efficiency of the solar cell 100.

In the above description, it is exemplified that the second electrode layer 422 of the first electrode 42 and the metal electrode layer 442 of the second electrode 44 have the same or similar planar shape while each having a pattern. However, the second electrode layer 422 of the first electrode 42 and the metal electrode layer 442 of the second electrode 44 may have different planar shapes. For example, when the solar cell 100 has a cross-sectional light-receiving structure in which no light is incident to the rear side, the second electrode 44 or the metal electrode layer 442 may be entirely formed on (formed in contact with) the photovoltaic part 10 (more specifically, the second electrode layer 126). As described above, the shape, the arrangement, and the like of the second electrode layer 422 of the first electrode 42 and the metal electrode layer 442 of the second electrode 44 may be variously modified.

In the present embodiment, the second electrode layer 422 or the metal electrode layer 442 may include a printed layer including a metal and a resin. Here, the second electrode layer 422 is formed in contact with the first electrode layer 420 and the insulating film is not provided on the surface of the second semiconductor layer 126 on which the metal electrode layer 442 is positioned, so a fire-through penetrating through the insulating film, etc., is not required. Accordingly, in the present embodiment, a printed layer may be formed using a low-temperature firing paste containing only a metal and a resin (a binder, a curing agent, and an additive) without containing a glass frit composed of a certain metal compound (e.g., an oxide containing oxygen, a carbide containing carbon, and a sulfide containing sulfur), etc.

More specifically, the printed layer may be formed by applying the low-temperature firing paste containing the metal and the resin without the glass frit and heat-treating the low-temperature firing paste to cure the low-temperature firing paste. As a result, the printed layer included in the second electrode layer 422 or the metal electrode layer 442 may have conductivity because a plurality of metal particles are aggregated by contacting each other without being sintered. For example, by curing the low-temperature firing paste at a lower temperature (e.g., 150°C or lower) than the temperature used in the conventional low-temperature process, in the printed layer included in the second electrode layer 422 or the metal electrode layer 442, the plurality of metal particles may not be completely necked and may have a shape in which the plurality of metal particles are connected while being in contact with each other.

As such, when the second electrode layer 422 or the metal electrode layer 442 includes the printed layer formed using the low-temperature firing paste, it is possible to form the second electrode layer 422 or the metal electrode layer 442 by a simple process, and it is possible to prevent the deterioration phenomenon in the first photovoltaic part 110 containing the perovskite compound from occurring in the process of forming the second electrode layer 422 or the metal electrode layer 442. However, the present disclosure is not limited thereto. The second electrode layer 422 or the metal electrode layer 442 may further include a separate metal layer or the like other than the printed layer, and the second electrode layer 422 or the metal electrode layer 442 does not include a printed layer, but may include a plating layer, a sputtering layer, and the like. Various other modifications are possible.

The second electrode layer 422 or the metal electrode layer 442 may contain various metals. For example, the second electrode layer 422 or the metal electrode layer 442 may contain various metals such as silver, copper, gold, and aluminum. In the present embodiment, the second electrode layer 422 and the metal electrode layer 442 may have the same materials, structures, shapes, thicknesses, etc., as each other or may have different materials, structures, shapes, thickness, etc., from each other. For example, the width of the second electrode layer 422 may be smaller than that of the metal electrode layer 442 and/or the thickness of the second electrode layer 422 may be greater than that of the metal electrode layer 442. This is to reduce a shading loss due to a second electrode layer 4220 positioned on the front side and sufficiently secure specific resistance, but the present disclosure is not limited thereto.

As described above, the photovoltaic part 10 according to the present embodiment may have a tandem structure in which the second photovoltaic part 120 based on a single semiconductor material (e.g., silicon) and the first photovoltaic part 110 based on the perovskite compound are bonded by the junction layer 110a. In this case, the first photovoltaic part 110 has a band gap larger than that of the second photovoltaic part 120. That is, the first photovoltaic part 110 has a relatively large bandgap, absorbs a short-wavelength having a relatively small wavelength, and uses the short-wavelength light to cause photoelectric conversion, and the second photovoltaic part 120 has a bandgap lower than that of the first photovoltaic part 110, effectively absorbs a long wavelength having a wavelength greater than that of light used in the first photovoltaic part 110, and uses the long wavelength to cause the photoelectric conversion.

In more detail, when light is incident through the front side of the solar cell 100, the first photovoltaic part 110 absorbs the short wavelength to generate electrons and holes by the photoelectric conversion. In this case, the first carrier is collected by moving to the first electrode 42, and the second carrier is collected by moving to the second electrode 420 through the first photovoltaic part 110 and the second photovoltaic part 120. When the long wavelength that is not used for the first photovoltaic part 110 and passes through the first photovoltaic part 110 reaches the second photovoltaic part 120, the second photovoltaic part 120 absorbs the long wavelength and generates the first carrier and the second carrier by the photoelectric conversion. In this case, the first carrier is collected by moving to the first electrode 42 through the first photovoltaic part 110, and the second carrier is collected by moving to the second electrode 44.

As described above, in the present embodiment, the first semiconductor layer 124 and the second semiconductor layer 126 included in the first photovoltaic part 110 have different crystal structures, and the first intermediate film 124a and the second intermediate film 126a may contain different materials. That is, the junction structure formed by the first intermediate film 124a and/or the first semiconductor layer 124 on one side of the first photovoltaic part 110 and the junction structure formed by the second intermediate film 126a and/or the first semiconductor layer 126 on the other side thereof are different from each other. In addition, the first electrode 42 adjacent to the first photovoltaic part 110 and the second electrode 44 adjacent to the second photovoltaic part 120 may have different layer structures. This will be described in more detail.

The first semiconductor layer 124 positioned on the front side of the semiconductor substrate 122 may include an amorphous portion (e.g., an amorphous layer) doped with a first conductive dopant. More specifically, in the present embodiment, the first semiconductor layer 124 is doped with the first conductive dopant and may include a hydrogenated amorphous portion (i.e., an amorphous portion containing hydrogen). For example, in the process of forming the first semiconductor layer 124, the first semiconductor layer 124 may be formed to contain hydrogen, which will be described in detail in the method of fabricating a solar cell 100.

Here, including the amorphous portion may mean including a portion not only having an amorphous structure as a whole, but also a portion having a crystalline structure but having a volume ratio of a portion having an amorphous structure greater than a volume ratio of a portion having a crystalline structure. For example, a portion in which nanocrystals, microcrystals, etc., are partially provided in a matrix having an amorphous structure may also be regarded as including an amorphous portion. Here, the nanocrystal may refer to crystals having a size (e.g., average size) of a nanometer level (e.g., 1 nm or more and less than 1 µm), and the microcrystal may refer to a crystal having a size (for example, an average size) of a micrometer level (e.g., 1 µm or more and less than 1 mm). These nanocrystals, microcrystals, etc., may be intentionally formed by controlling process conditions, or may be formed naturally during the process. For example, when the first semiconductor layer 124 is formed to include hydrogen, crystallization may occur in some portions of the amorphous portion or the size of the crystals present in the amorphous portion may be increased while defects are removed by hydrogen, so the nanocrystals, the microcrystals, etc., may be formed.

For example, the first semiconductor layer 124 may include at least one of an amorphous silicon layer doped with a first conductive dopant and containing hydrogen, an amorphous silicon oxide layer, and an amorphous silicon carbide layer. Here, the amorphous silicon, the amorphous silicon oxide layer, or the amorphous silicon carbide layer may mean having an amorphous portion including silicon, silicon oxide, or silicon carbide as a main material. For example, the first semiconductor layer 124 may be configured as an amorphous silicon layer doped with a first conductive dopant, containing hydrogen, and having an amorphous structure as a whole.

For example, when the first semiconductor layer 124 includes an amorphous silicon layer, it is possible to minimize the difference in characteristics with the semiconductor substrate 122 by containing the same semiconductor material as that of the semiconductor substrate 122. As another example, when the first semiconductor layer 124 includes an amorphous silicon oxide layer or an amorphous silicon carbide, the first semiconductor layer 124 may have a high energy bandgap to effectively move carriers and may include a semiconductor material included in the semiconductor substrate 122 to have characteristics similar to those of the substrate 122.

As such, when the first semiconductor layer 124 includes the amorphous portion, the first semiconductor layer 124 contains a lot of hydrogen to improve the hydrogen passivation characteristics, and the first semiconductor layer has excellent matchability with the first photovoltaic part 110 and/or the junction layer 110a, and thus may have excellent passivation characteristics and excellent connection characteristics.

The first intermediate film 124a positioned between the first semiconductor layer 124 and the semiconductor substrate 122 contains a semiconductor material to improve electrical connection characteristics between the first semiconductor layer 124 and the semiconductor substrate 122. For example, since the first intermediate film 124a contains intrinsic amorphous silicon to minimize a lattice mismatch with the semiconductor substrate 122 and effectively prevent a recombination on the surface of the semiconductor substrate 122, thereby improving passivation characteristics. For example, the first intermediate film 124a may be a hydrogenated intrinsic amorphous silicon layer (i.e., an intrinsic amorphous silicon layer including hydrogen). Thereby, it is possible to improve the passivation characteristics.

Accordingly, the semiconductor substrate 122 and the first semiconductor layer 124 may include the same semiconductor material (e.g., silicon) with the first intermediate film 124a composed of the semiconductor material (e.g., silicon) therebetween, and may have a hetero-junction structure having different crystal structures.

The second semiconductor layer 126 positioned on the rear side of the semiconductor substrate 122 may include an amorphous portion (e.g., a polycrystalline layer) doped with a second conductive dopant. More specifically, in the present embodiment, the first semiconductor layer 124 is doped with the second conductive dopant and may include a hydrogenated polycrystalline portion (i.e., an amorphous portion containing hydrogen). To this end, for example, the process of injecting hydrogen in which hydrogen is injected into the second semiconductor layer 126 may be performed in order to improve the passivation characteristics of the second semiconductor layer 126. Since the process of forming the second semiconductor layer 126 is performed at a higher temperature than the process of forming the first semiconductor layer 124, even if hydrogen is present in the first semiconductor layer 124, dehydrogenation may occur during the process of forming the first semiconductor layer 124. Accordingly, unlike the first semiconductor layer 124, the process of injecting hydrogen is additionally performed, which will be described in more detail in the method of fabricating a solar cell 100.

Here, including the polycrystalline portion may mean including a portion not only having a polycrystalline structure as a whole, but also a portion having a crystalline structure but having a volume ratio of a portion having a polycrystalline structure greater than a volume ratio of a portion having an amorphous structure. For example, in the present embodiment, the second semiconductor layer 126 may be configured as a polycrystalline semiconductor layer having the polycrystalline structure as a whole, and thus, may have excellent photoelectric conversion efficiency and excellent electrical characteristics.

For example, the second semiconductor layer 126 may include a polycrystalline silicon layer doped with a second conductive dopant and containing hydrogen. Here, the polycrystalline silicon layer may mean having a polycrystalline portion containing silicon as a main material. For example, the second semiconductor layer 126 may be configured as an amorphous silicon layer doped with the second conductive dopant, containing hydrogen, and having the polycrystalline structure as a whole.

As such, when the second semiconductor layer 126 includes the polycrystalline portion, the second semiconductor layer 126 may have high carrier mobility, and thus, may have excellent photoelectric conversion efficiency and excellent electrical characteristics.

The second intermediate film 126a positioned between the second semiconductor layer 126 and the semiconductor substrate 122 may serve as a passivation film passivating the surface of the semiconductor substrate 122. Alternatively, the second intermediate film 126a may serve as a dopant control role or a diffusion barrier preventing the second conductive dopant of the second semiconductor layer 126 from excessively diffusing the dopant into the semiconductor substrate 122. For example, the second intermediate film 126a may act as a kind of barrier to electrons and holes to prevent minority carriers from passing and to may be accumulated in a portion adjacent to the second intermediate film 126a, and only majority carriers having a predetermined or higher energy may be accumulated in a portion adjacent to the second intermediate film 126a, and then pass through the second intermediate film 126a. That is, the second intermediate film 126a may be a kind of tunneling film. In this case, the majority carriers having certain energy or more may easily pass through the second intermediate film 126a due to the tunneling effect.

The second intermediate film 126a may include various materials capable of performing the above-described functions, for example, an insulating material. When the second intermediate film 126a includes an insulating material, the carrier transport to the second semiconductor layer 126 including the polycrystalline portion may be smoothly performed. For example, the second intermediate film 126a may be formed of an oxide film, a dielectric film or an insulating film containing silicon, a nitride oxide film, a carbonized oxide film, or the like. For example, when the second intermediate film 126a is formed of a silicon oxide film, the second intermediate film 126a may be easily fabricated and carriers can be smoothly transported through the second intermediate film 126a.

As a result, the semiconductor substrate 122, the second semiconductor layer 126, and/or the second intermediate film 126a may include the same semiconductor material (e.g., silicon), and have an insulation-junction structure or a tunnel-junction structure in which the semiconductor substrate 122 and the second semiconductor layer 126 and/or the second intermediate film 126a is bonded with the second intermediate film 126a (i.e., insulating film) composed of an insulating material therebetween. In this case, since the thickness of the second intermediate film 126a is thin, the movement of carriers may not be hindered.

In the present embodiment, the second semiconductor layer 126 positioned on the rear side of the semiconductor substrate 122 includes polycrystalline portion absorbing a relatively large amount of light, and the first semiconductor positioned on the front side of the semiconductor substrate 122 includes an amorphous portion absorbing less light than the second semiconductor layer 126. Accordingly, unwanted light absorption on the front side of the semiconductor substrate 122 may be minimized. In addition, in the second semiconductor layer 126 positioned on the rear side of the semiconductor substrate 122, it is possible to effectively improve the carrier movement characteristics, the electrical connection characteristics, etc.

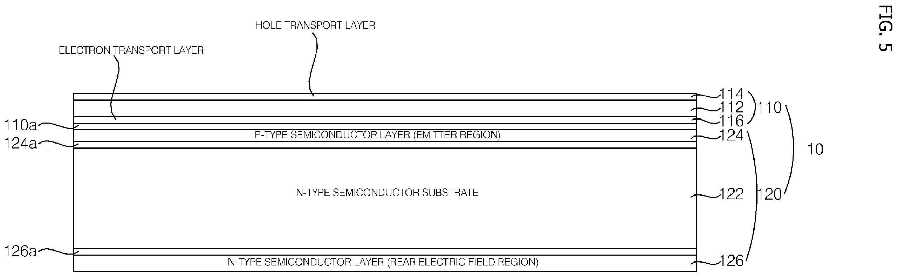

In addition, the first semiconductor layer 124 and/or the first intermediate film 124a positioned adjacent to the first photovoltaic part 110 may include the amorphous portion to improve the matchability with the first photovoltaic part 110 containing the perovskite compound, thereby improving the carrier movement characteristics. In addition, since the first semiconductor layer 124 including the amorphous portion contains hydrogen and may have excellent hydrogen passivation characteristics, the passivation film positioned between the junction layer 110a and the first semiconductor layer 124 may be removed in order to improve the existing hydrogen passivation characteristics. Since the passivation film is an insulating film composed of an insulating material, when the passivation film is positioned between the junction layer 110a and the first semiconductor layer 124, it is possible to hinder the movement of carriers through the first photovoltaic part 110 and the second photovoltaic part 120. This will be described in more detail later with reference to FIG. 5. For example, the first semiconductor layer 124 may directly contact the first photovoltaic layer 110 with the junction layer 110a interposed therebetween. That is, the junction layer 110a may be positioned to be in contact with the first semiconductor layer 124, and the first photovoltaic layer 110 may be positioned to be in contact with the junction layer 110a. Then, the structure may be simplified, and the carrier may move smoothly.

In addition, the second semiconductor layer 126 positioned on a surface opposite to a side on which the first photovoltaic part 110 is positioned on the semiconductor substrate 122 may include a polycrystalline portion to effectively improve the carrier movement characteristics, the electrical connection characteristics, etc.

In this case, the thickness of the second semiconductor layer 126 may be equal to or greater than the thickness of the first semiconductor layer 124. For example, the thickness of the second semiconductor layer 126 may be equal to or greater than that of the first semiconductor layer 124. This is because even if the second semiconductor layer 126 is positioned on the rear side of the semiconductor substrate 122 and has a relatively large thickness, the degree of hindering the incident light may not be large. Alternatively, the thickness of the first semiconductor layer 124 may be 10 nm or less (e.g., 5 nm to 10 nm), and the thickness of the second semiconductor layer 126 may be 10 nm or more (e.g., greater than 10 nm and 500 nm or less). These thicknesses consider the characteristics of the first semiconductor layer 124 and the second semiconductor layer 126, the amount of light passing therethrough, and the like, but the present disclosure is not limited thereto.

In addition, the thickness of the first intermediate film 124a or the second intermediate film 126a may be smaller than that of the first semiconductor layer 124 and that of the second semiconductor layer 126, respectively. More specifically, the thickness of the second intermediate film 126a may be equal to or smaller than that of the first intermediate film 124a. For example, the thickness of the second intermediate film 126a may be smaller than that of the first intermediate film 124a. As a result, the second carrier may smoothly pass through (e.g., tunnel) the second intermediate film 125a composed of the insulating material, and the first intermediate film 126a has a relatively thick thickness, thereby exhibiting excellent passivation characteristics. Alternatively, the thickness of the first intermediate film 124a may be 8 nm or less (e.g., 2 nm to 8 nm) and the thickness of the second intermediate film 126a may be 3 nm or less (e.g., 1 nm to 3 nm). The thickness is taken into consideration of the roles of the first intermediate film 124a and the second intermediate film 126a, but the present disclosure is not limited thereto.

Accordingly, in the present embodiment, a thickness ratio of the first semiconductor layer 126 to the second intermediate film 126b may be greater than that of the first semiconductor layer 124 to the first intermediate film 124a As a result, it is possible to effectively improve the characteristics of the first intermediate film 124a and the first semiconductor layer 124, and the second intermediate film 126a and the second semiconductor layer 126 that have different crystal structures and constitute different junction structures.

In the present embodiment, a hydrogen content of the first semiconductor layer 124 may be greater than that of the second semiconductor layer 126. This is because, since the first semiconductor layer 124 has a relatively large number of defects including an amorphous structure, there is more space for hydrogen bonding. As described above, by increasing the hydrogen content of the first semiconductor layer 124, it is possible to further improve the passivation characteristics of the first semiconductor layer 124. For example, the hydrogen content of the first semiconductor layer 124 may be 1×10²⁰ pieces/cm³ or more (e.g., 8×10²¹ pieces/cm³ or less), and the hydrogen content of the second semiconductor layer 126 may be 8×10²⁰ pieces/cm³ or less (for example, 1×10¹⁹ pieces/cm³ or more). This is limited to maximize efficiency in consideration of the crystal structure, position, role, and the like of the first semiconductor layer 124 and the second semiconductor layer 126, but the present disclosure is not limited thereto.

In addition, the hydrogen content of the first intermediate film 124a may be greater than that of the second intermediate film 126a. This is because the first intermediate film 124a is composed of a semiconductor material having an amorphous structure and thus has more space for hydrogen bonding. As described above, by increasing the hydrogen content of the first intermediate film 124a, it is possible to further improve the passivation characteristics of the first intermediate film 124a. For example, the hydrogen content of the first intermediate film 124a may be 1×10²⁰ pieces/cm³ or more (e.g., 8×10²¹ pieces/cm³ or less), and the hydrogen content of the second intermediate layer 126a may be 1×10²⁰ pieces/cm³ or less (for example, 1×10¹⁸ pieces/cm³ or more). Alternatively, the hydrogen content of the second intermediate film 126a may be equal to or smaller than that of the second semiconductor layer 126, and may be equal to or smaller than that of the first semiconductor layer 124. In particular, the hydrogen content of the second intermediate film 126a may be smaller than that of the second semiconductor layer 126 and smaller than that of the first semiconductor layer 124. This is limited to maximize efficiency in consideration of materials, positions, roles, etc. of the first intermediate film 124a and the second intermediate film 126a, but the present disclosure is not limited thereto. For reference, the first intermediate film 124a and the first semiconductor layer 124 are different from each other only in terms of whether the first conductive dopant is included and have the same material and the same crystal structure, and therefore, may have the same as or similar level to the hydrogen content.

In addition, as described above, the first electrode 42 positioned on the first photovoltaic part 110 and the second electrode 44 positioned on the second semiconductor layer 126 of the second photovoltaic part 120 may have different stacked structures. More specifically, since the first photovoltaic part 110 containing the perovskite compound has low carrier mobility, in addition to the second electrode layer 422, the first electrode layer 420 composed of a transparent conductive material as a whole is provided to lower the horizontal resistance. On the other hand, since the second semiconductor layer 126 has a polycrystalline structure or a polycrystalline portion having excellent carrier mobility, only the metal electrode layer 442 directly connected to the second semiconductor layer 126 without a separate transparent electrode layer composed of a transparent conductive material may be provided. As a result, since the second electrode 44 does not include a separate transparent electrode layer composed of a transparent conductive material, material costs may be reduced and the process may be simplified. However, the present disclosure is not limited thereto, and the second electrode 44 may further include a transparent electrode layer positioned between the second semiconductor layer 126 and the metal electrode layer 442. Various other modifications are possible.

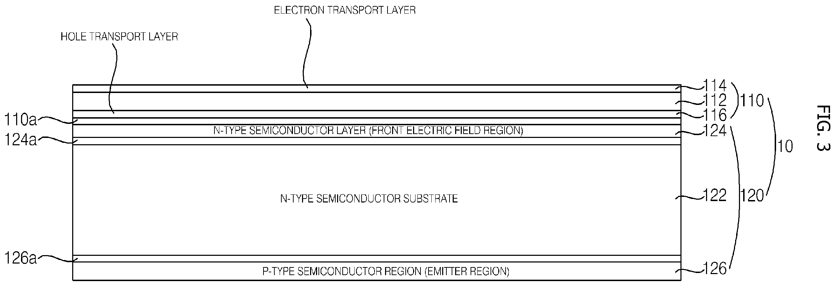

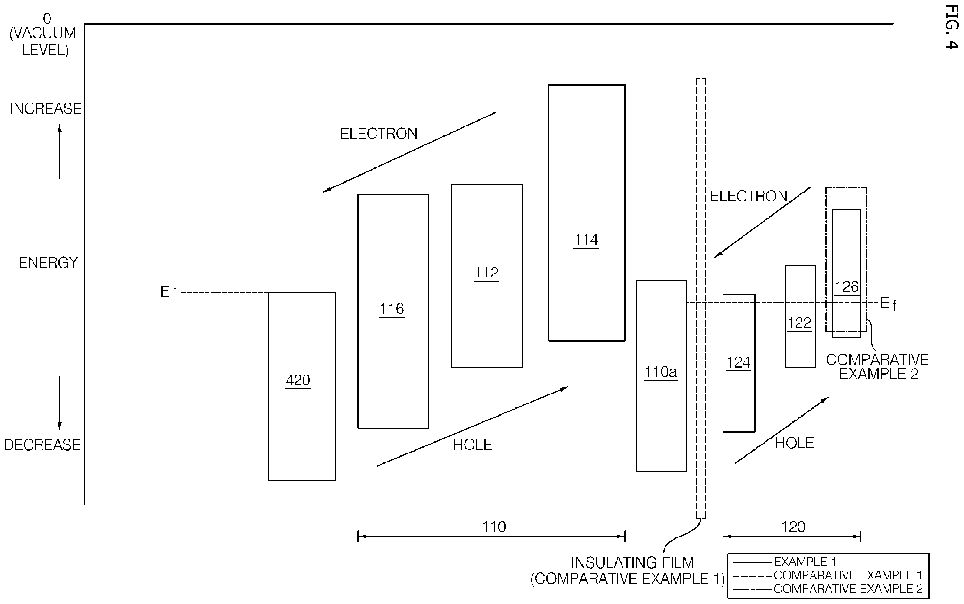

As described above, the roles, materials, or the like of the first and second semiconductor layers 124 and 126 and the first and second transport layers 114 and 116 may be changed according to the conductivity type of the semiconductor substrate 122 and the first and second semiconductor layers 124 and 126. In consideration of this, the structure of the solar cell 100 according to an example of the present embodiment will be described with reference to FIG. 3, and the carrier movement characteristics thereof will be described with reference to FIG. 4.

FIG. 3 is a diagram schematically illustrating an example of conductivity types and roles of a plurality of layers included in a photovoltaic part of a solar cell 100 according to an embodiment of the present disclosure. For clear understanding, FIG. 3 does not specifically illustrate the uneven or anti-reflection structure and the like, but mainly illustrates the stacking order, conductivity types, and roles of the plurality of layers included in the photovoltaic part 10.

Referring to FIG. 3, in this example, the semiconductor substrate 122 may have an n-type. When the semiconductor substrate 122 has an n-type, bulk characteristics are excellent and a life time of carriers may be improved.

In the present embodiment, the first semiconductor layer 124 has an n-type which is the same conductivity type as the semiconductor substrate 122, but may have a higher doping concentration than the semiconductor substrate 122, and the second semiconductor layer 126 may have a p-type which is a conductivity type different from that of the semiconductor substrate 122. Accordingly, the second semiconductor layer 126 positioned on the rear side of the semiconductor substrate 122 may constitute an emitter region forming a pn junction with the semiconductor substrate 122, and the first semiconductor layer 124 positioned on the front side of the semiconductor substrate 122 may constitute a front electric field region that prevents recombination by forming a front side field. Then, since the emitter region directly involved in the photoelectric conversion is positioned on the rear side, the emitter region may be formed to a sufficient thickness (e.g., to be thicker than the front electric field region), thereby improving photoelectric conversion efficiency. In addition, in the first photovoltaic part 110, the first semiconductor layer 124 having the polycrystalline structure constitutes an emitter region, thereby improving electrical characteristics in the emitter region directly involved in the photoelectric conversion. In addition, the light loss may be minimized by thinly forming the first semiconductor layer 124 which is the front electric field region thin.

In this case, in the first photovoltaic part 110 positioned on the second photovoltaic part 120, the first transport layer 114 positioned on the upper side may be configured as an electron transport layer that transports electrons, and the second transport layer 116 positioned on the lower side may be configured as a hole transport layer that transports holes. In this case, the first photovoltaic part 110 may have an excellent effect.

In this solar cell 100, when light is incident through the front side of the solar cell 100, the first photovoltaic part 110 absorbs the short wavelength to generate electrons and holes by the photoelectric conversion. In this case, electrons are collected by moving to the first electrode 42 through the first transport layer 114, and holes are collected by moving to the second electrode 44 through the second transport layer 116 and the second photovoltaic part 120. When the long wavelength that is not used for the first photovoltaic part 110 and passes through the first photovoltaic part 110 reaches the second photovoltaic part 120, the second photovoltaic part 120 absorbs the long wavelength and generates electrons and holes by the photoelectric conversion. In this case, electrons are collected by moving to the first electrode 42 through the first semiconductor layer 124 and the first photovoltaic part 110, and holes are collected by moving to the second electrode 44 through the second semiconductor layer 126.

FIG. 4 is an energy band diagram schematically illustrating energy bands of the solar cell illustrated in FIG. 3 and solar cells according to Comparative Examples 1 and 2. In FIG. 4, the illustration of the first and second intermediate films, the second electrode layer of the first electrode, and the second electrode are omitted.

Here, in the solar cell according to Comparative Example 1, a first conductive region including a doped region formed by additionally doping a portion of the semiconductor substrate with a first conductive dopant is positioned on the front side of the semiconductor substrate, and a passivation film (insulating film) is provided between the first conductive region and the junction layer to improve the passivation characteristics. As described above, the solar cell according to Comparative Example 1 has the same structure as the solar cell and the photovoltaic part according to the present Example, except that the first conductive region and the passivation film are provided instead of the first intermediate film and the first semiconductor layer according to the present example. The solar cell according to Comparative Example 2 has the same structure as the solar cell according to the present example, except that the second semiconductor layer 126 includes the amorphous portion instead of the polycrystalline portion.

Referring to FIG. 4, in the present example, the energy band diagram in which holes and electrons smoothly move in the first photovoltaic part 110 and the second photovoltaic part 120 is provided. That is, in each of the first photovoltaic part 110 and the second photovoltaic part 120, energy of a conduction band has a tendency to gradually decrease in the direction of the flow of electrons, and energy of a valence band has a tendency to gradually increase in the direction of the flow of electrons. That is, since the first semiconductor layer 124 includes an amorphous portion having a low energy bandgap (1.5 to 1.7eV) to form an energy band diagram in which carriers may flow smoothly, the carrier movement characteristics are very excellent.

On the other hand, in the solar cell according to Comparative Example 1, it can be seen that a passivation film (insulating film) having a very large energy bandgap, for example, an energy bandgap of 9.0 eV is positioned between the first conductive region and the junction layer 110a to greatly hinder the movement of carriers As in Comparative Example 1, when the first conductive region having the first conductive dopant is composed of a doped region including a portion of the semiconductor substrate, the passivation film (insulating film) covering the first conductive region is provided to improve the passivation characteristics. However, when the energy band greatly increases in the flow direction of electrons by the passivation film having such a large energy band gap, the passivation film acts as a kind of barriers, and as a result, the carrier movement characteristics may be greatly reduced. Accordingly, in the solar cell according to Comparative Example 1, it was difficult to improve both the passivation characteristics and the carrier movement characteristics.

Compared with the solar cell according to Comparative Example 2 in which the second semiconductor layer positioned on the rear side has an amorphous portion, in the solar cell according to the present example, there is a slight difference in the band gap in the second semiconductor layer. However, it can be seen that this difference is not enough to significantly affect the carrier movement characteristics related to the flow of carriers. In consideration of this, in the solar cell according to the present example, the efficiency of the solar cell is improved by configuring the second semiconductor layer as a polycrystalline portion in consideration of the carrier mobility rather than the bandgap side.

FIG. 4 illustrates the structure of the solar cell 100 illustrated in FIG. 3 as an example. Even when the conductivity types of the semiconductor substrate 122 and the first and second semiconductor layers 124 and 126 are different, the tendency of the energy band diagram may have a tendency to improve the carrier movement characteristics. Other examples other than the solar cell 100 illustrated in FIG. 3 will be described in detail with reference to FIGS. 5 to 7. FIGS. 5 to 7 are illustrated to correspond to FIG. 3.

FIG. 5 is a diagram schematically illustrating another example of the conductivity types and roles of the plurality of layers included in the solar cell according to the embodiment of the present disclosure.

Referring to FIG. 5, the semiconductor substrate 122 has an n-type, the first semiconductor layer 124 has a p-type that is a conductivity type different from that of the semiconductor substrate 122, and the second semiconductor layer 126 may have the same n-type as the semiconductor substrate 122, but may have a higher doping concentration than that of the semiconductor substrate 122. Then, the first semiconductor layer 124 may constitute an emitter region and the second semiconductor layer 126 may constitute a rear electric field region. In addition, in the first photovoltaic part 110, the second transport layer 116 may be configured as an electron transport layer that transports electrons, and the first transport layer 114 may be configured as a hole transport layer that transports holes.

As described above, when the semiconductor substrate 122 has an n-type, the life time of the carrier may be improved. The first semiconductor layer 124 constituting the emitter region is positioned on the front side of the semiconductor substrate 122, so the pn junction formed by the semiconductor substrate 120 and the first semiconductor layer 124 may be positioned on the front side. As a result, it is possible to minimize an optical path reaching the pn junction. In addition, the passivation characteristics of the second semiconductor layer 126 including the n-type polycrystalline portion may be superior to the passivation characteristics of the p-type polycrystalline portion. This is because the n-type dopant included in the second semiconductor layer 126 causes less damage to the second intermediate film 126b than the p-type dopant (e.g., boron).

In this solar cell 100, when light is incident through the front side of the solar cell 100, the first photovoltaic part 110 absorbs the short wavelength to generate electrons and holes by the photoelectric conversion. In this case, holes are collected by moving to the first electrode 42 through the first transport layer 114, and electrons are collected by moving to the second electrode 44 through the second transport layer 116 and the second photovoltaic part 120. When the long wavelength that is not used for the first photovoltaic part 110 and passes through the first photovoltaic part 110 reaches the second photovoltaic part 120, the second photovoltaic part 120 absorbs the long wavelength and generates electrons and holes by the photoelectric conversion. In this case, holes are collected by moving to the first electrode 42 through the first semiconductor layer 124 and the first photovoltaic part 110, and electrons are collected by moving to the second electrode 44 through the second semiconductor layer 126.

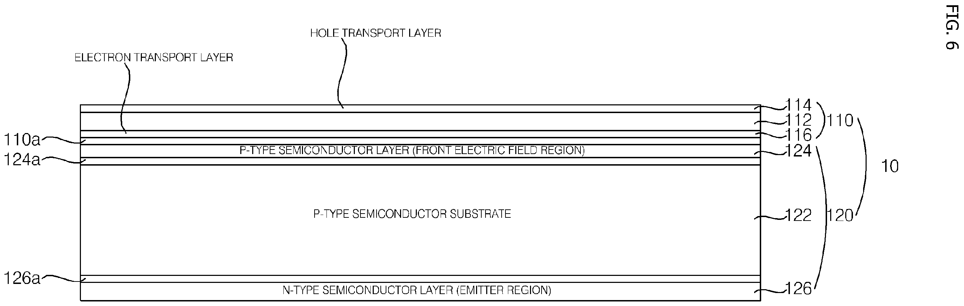

FIG. 6 is a diagram schematically illustrating another example of the conductivity types and roles of the plurality of layers included in the solar cell according to the embodiment of the present disclosure.

Referring to FIG. 6, in the second photovoltaic part 120, the semiconductor substrate 122 has a p-type, and the first semiconductor layer 124 has a p-type that is the same conductivity type as the semiconductor substrate 122 and has a doping concentration higher than that of the semiconductor substrate 122, and the second semiconductor layer 126 may have an n-type conductivity type different from that of the semiconductor substrate 122. Then, the second semiconductor layer 124 may constitute an emitter region and the first semiconductor layer 126 may constitute a front electric field region. In addition, in the first photovoltaic part 110, the second transport layer 116 may be configured as an electron transport layer that transports electrons, and the first transport layer 114 may be configured as a hole transport layer that transports holes.

As such, when the semiconductor substrate 122 has a p-type, the price is inexpensive, and thus, material costs may be reduced. Then, since the emitter region directly involved in the photoelectric conversion is positioned on the rear side, the emitter region may be formed to a sufficient thickness (e.g., to be thicker than the front electric field region), thereby improving photoelectric conversion efficiency. In addition, in the first photovoltaic part 110, the first semiconductor layer 124 having the polycrystalline structure constitutes an emitter region, thereby improving electrical characteristics in the emitter region directly involved in the photoelectric conversion. In addition, the second semiconductor layer 126 including the n-type polycrystalline portion may have excellent passivation characteristics. In addition, the light loss may be minimized by thinly forming the first semiconductor layer 124 which is the front electric field region thin.

In this solar cell 100, when light is incident through the front side of the solar cell 100, the first photovoltaic part 110 absorbs the short wavelength to generate electrons and holes by the photoelectric conversion. In this case, holes are collected by moving to the first electrode 42 through the first transport layer 114, and electrons are collected by moving to the second electrode 44 through the second transport layer 116 and the second photovoltaic part 120. When the long wavelength that is not used for the first photovoltaic part 110 and passes through the first photovoltaic part 110 reaches the second photovoltaic part 120, the second photovoltaic part 120 absorbs the long wavelength and generates electrons and holes by the photoelectric conversion. In this case, holes are collected by moving to the first electrode 42 through the first semiconductor layer 124 and the first photovoltaic part 110, and electrons are collected by moving to the second electrode 44 through the second semiconductor layer 126.

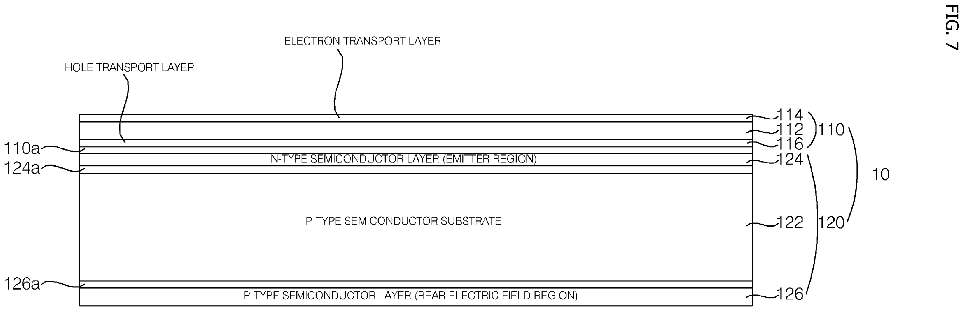

FIG. 7 is a diagram schematically illustrating another example of the conductivity types and roles of the plurality of layers included in the solar cell according to the embodiment of the present disclosure.

Referring to FIG. 7, the semiconductor substrate 122 has a p-type, the first semiconductor layer 124 has an n-type that is a conductivity type different from that of the semiconductor substrate 122, and the second semiconductor layer 126 may have the p-type which is the same conductivity type as the semiconductor substrate 122, but may have a higher doping concentration than that of the semiconductor substrate 122. Then, the first semiconductor layer 124 may constitute an emitter region and the second semiconductor layer 126 may constitute a rear electric field region. In addition, in the first photovoltaic part 110, the second transport layer 116 may be configured as a hole transport layer that transports holes, and the first transport layer 114 may be configured as an electron transport layer that transports electrons.

As such, when the semiconductor substrate 122 has a p-type, the price is inexpensive, and thus, material costs may be reduced. The first semiconductor layer 124 constituting the emitter region is positioned on the front side of the semiconductor substrate 122, so the pn junction formed by the semiconductor substrate 120 and the first semiconductor layer 124 may be positioned on the front side. As a result, it is possible to minimize an optical path reaching the pn junction.

In this solar cell 100, when light is incident through the front side of the solar cell 100, the first photovoltaic part 110 absorbs the short wavelength to generate electrons and holes by the photoelectric conversion. In this case, electrons are collected by moving to the first electrode 42 through the first transport layer 114, and holes are collected by moving to the second electrode 44 through the second transport layer 116 and the second photovoltaic part 120. When the long wavelength that is not used for the first photovoltaic part 110 and passes through the first photovoltaic part 110 reaches the second photovoltaic part 120, the second photovoltaic part 120 absorbs the long wavelength and generates electrons and holes by the photoelectric conversion. In this case, electrons are collected by moving to the first electrode 42 through the first semiconductor layer 124 and the first photovoltaic part 110, and holes are collected by moving to the second electrode 44 through the second semiconductor layer 126.

As such, according to the present embodiment, the first semiconductor layer 124 includes a hydrogenated amorphous portion containing hydrogen to improve passivation characteristics, and improve matchability with the first photovoltaic part 110 containing a perovskite compound to improve carrier movement characteristics. In addition, the second semiconductor layer 126 may include a polycrystalline portion having excellent carrier mobility to improve carrier movement characteristics, reduce material costs of the second electrode 44, and simplify a fabricating process. As a result, the efficiency and productivity of the solar cell 100 having the tandem structure may be improved.

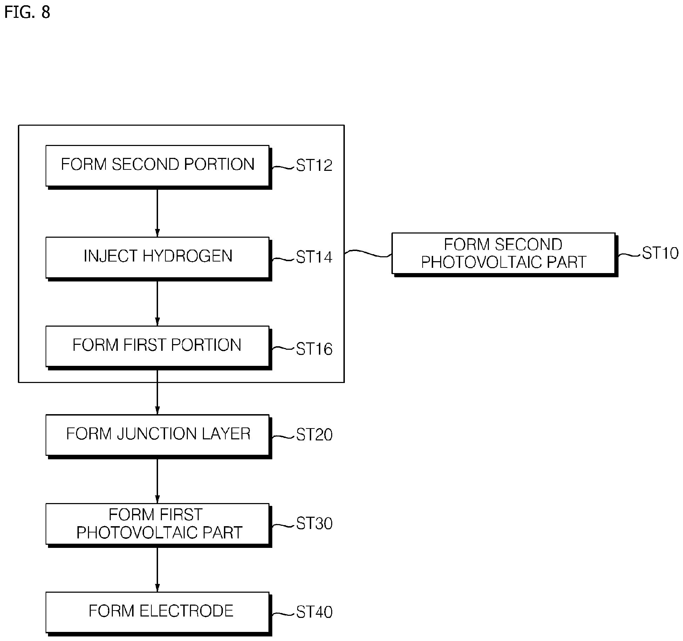

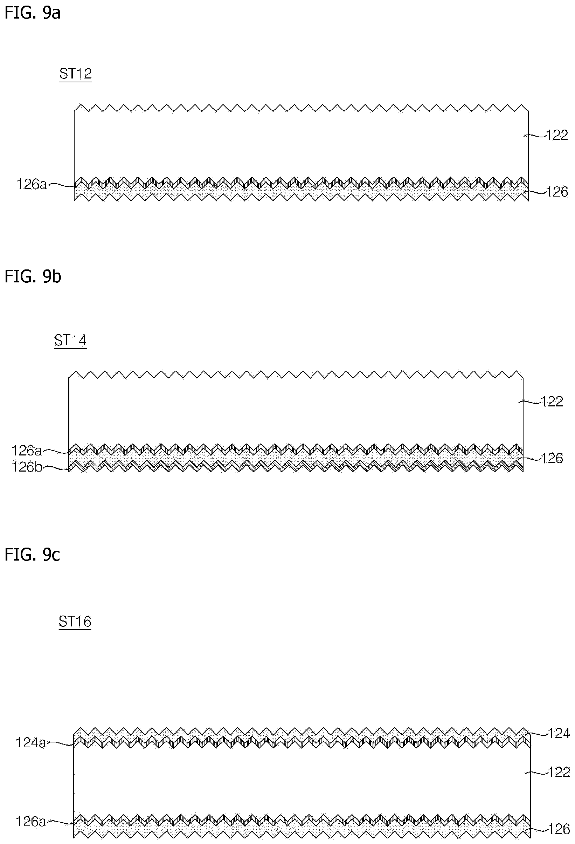

A method of manufacturing a solar cell 100 having the above-described structure will be described in detail with reference to FIG. 8 and FIGS. 9A to 9F. In the above description, detailed descriptions of the parts already described will be omitted, and the parts that have not been described will be mainly described in detail.

FIG. 8 is a flowchart of a method of fabricating a solar cell according to an embodiment of the present disclosure, and FIGS. 9A to 9F are cross-sectional views illustrating a method of fabricating a solar cell according to an embodiment of the present disclosure.

Referring to FIG. 8, the method of fabricating a solar cell 100 according to the present embodiment includes a second photovoltaic part forming step ST10, a junction layer forming step ST20, a first photovoltaic part forming step ST30, and an electrode forming step ST40. Here, the second photovoltaic part forming step ST10 may include a second portion forming step ST12 and a first portion forming step ST16. It may further include a hydrogen injecting step ST14 after the second portion forming step ST12. This will be described in detail together with FIGS. 9A to 9F.

As illustrated in FIG. 9A, in the second portion forming step ST12, the second intermediate film 126a and/or the second semiconductor layer 126 is formed on the other side (e.g., the rear side) of the semiconductor substrate 122.

More specifically, first, a semiconductor substrate 122 including a base region having a first or second conductive dopant is prepared. In this case, at least one of the front side and the rear side of the semiconductor substrate 122 may be textured to have unevenness to have an anti-reflection structure. As texturing of the surface of the semiconductor substrate 122, wet or dry texturing may be used. The wet texturing may be performed by immersing the semiconductor substrate 122 in a texturing solution, and has the advantage of a short process time. In the dry texturing, the surface of the semiconductor substrate 122 is cut using a diamond grill, a laser, or the like, and the unevenness may be uniformly formed, but the processing time is long and the damage to the semiconductor substrate 122 may occur. In addition, the semiconductor substrate 122 may be textured by reactive ion etching (RIE) or the like. As described above, in the present disclosure, the semiconductor substrate 122 may be textured using various methods.

Subsequently, the second intermediate film 126a and the second semiconductor layer 126 are entirely formed on the other side of the semiconductor substrate 122. In this case, after the second intermediate film 126a and the second semiconductor layer 126 are entirely formed on the front side and the rear side of the semiconductor substrate 122, and optionally formed on the side, the second intermediate film 126a and the second semiconductor layer 126 may be formed on the other side of the semiconductor substrate 122 by removing the second intermediate film 126a and the second semiconductor layer 126 formed on the front side and/or the side surface of the semiconductor substrate 122. Thereby, after forming the second intermediate film 126a and the second semiconductor layer 126 using a double-sided deposition process that may easily form the second intermediate film 126a and the second semiconductor layer 126, the second intermediate film 126a and the second semiconductor layer 126 may remain only on the desired rear side by the cross-sectional etching process. However, the present disclosure is not limited thereto, and the second intermediate film 126a and the second semiconductor layer 126 may be formed by a single-sided deposition process. Various other modifications are possible.

For example, the second intermediate film 126a may be formed by a thermal oxidation method, a vapor deposition method (e.g., chemical vapor deposition (CVD), atomic layer deposition (ALD)), or the like. For example, the second semiconductor layer 126 may be formed by a deposition method (e.g., chemical vapor deposition (CVD), for example, low-pressure compound vapor deposition (LPCVD)) or the like. In the present embodiment, the second semiconductor layer 126 may include a polycrystalline portion composed of a semiconductor material including a second conductive dopant. The second semiconductor layer 126 is formed by being deposited with a second conductive dopant, and may be additionally subjected to an activation heat treatment or the like, and may be formed by depositing an intrinsic semiconductor material to form a semiconductor layer and then doping a second conductive dopant by a doping process. In addition, it may be deposited in the form of the second semiconductor layer 126 including the polycrystalline portion, or the second semiconductor layer 126 may include the polycrystalline portion by performing a recrystallization process after deposition in the form of the amorphous portion.

As an example, the second intermediate film 126a and the second intermediate film 126a may be sequentially formed on the rear side of the semiconductor substrate 122 using an in-situ process for changing the type of gas used in a continuous process within the same equipment. For example, in a low pressure chemical vapor deposition apparatus, the second semiconductor layer 126 may be formed at a temperature of 600 to 800°C and a pressure lower than normal pressure (e.g., 1 torr or less), and under a gas atmosphere including a silicon-containing gas (e.g., silane (SiH₄)), hydrogen gas (H₂), a gas (e.g., PH₃, BBr₃, etc.) containing a dopant including a second conductive dopant, etc. Accordingly, the second semiconductor layer 126 including the second conductive dopant and hydrogen and having a polycrystalline portion may be easily formed by a simple process. In this case, the second intermediate film 126a may be formed by thermal oxidation under the gas atmosphere including oxygen-containing gas in the low-pressure chemical vapor deposition apparatus. Then, the process may be simplified by forming the second intermediate film 126a and the second semiconductor layer 126 in a continuous process. However, the present disclosure is not limited thereto, and the second intermediate film 126b and the second semiconductor layer 126 may be formed by various methods.

Subsequently, as illustrated in FIG. 9B, in the hydrogen injecting step ST14, hydrogen is injected into the second semiconductor layer 126 and/or the second intermediate film 126a. As described above, since the second semiconductor layer 126 is formed at a high temperature of 600 to 800°C, even if hydrogen is included in the second semiconductor layer 126, the second semiconductor layer 126 may be dehydrogenated by a high temperature. Accordingly, after the semiconductor layer 126 is formed, the hydrogen injecting step ST14 is performed to inject hydrogen into the semiconductor layer 126 to increase the hydrogen content, so the hydrogen passivation occurs sufficiently.

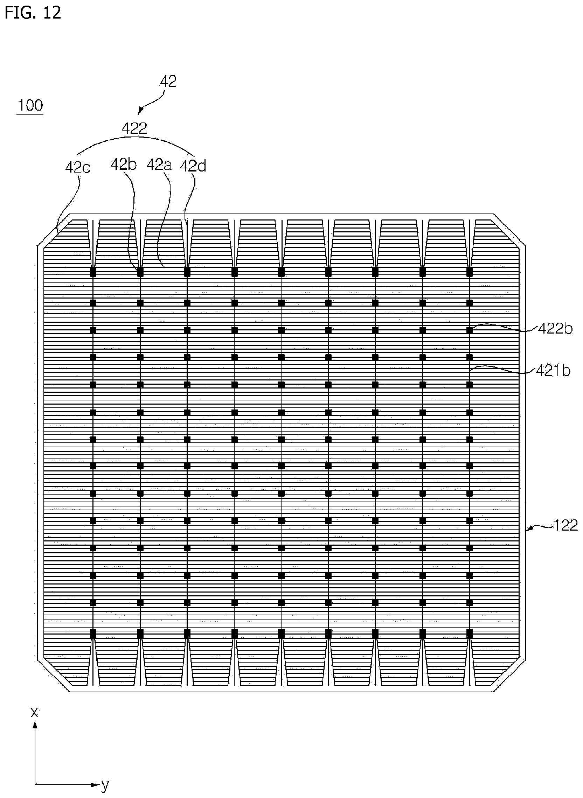

FIG. 9B illustrates that the hydrogen injection layer 126a containing hydrogen is formed on the second semiconductor layer 126 positioned on the rear side of the semiconductor substrate 122 and heat-treated at a temperature higher than room temperature (e.g., 400 to 600°C) to inject the hydrogen Here, as the hydrogen injection layer 126a, an insulating layer capable of containing hydrogen in a high content, for example, a silicon nitride layer containing hydrogen, an aluminum oxide layer containing hydrogen, or the like may be used. FIG. 9B illustrates that the hydrogen injection layer 126a is removed after the hydrogen injecting step ST14. However, the present disclosure is not limited thereto, and the hydrogen injection layer 126a may remain and may be used as a rear passivation film 126, a reflective film, an anti-reflection film, and the like, as illustrated in FIG. 12. Various other modifications are possible.

In addition, the hydrogen injection method of the hydrogen injecting step ST14 is not limited to the above-described method. For example, in a mixed gas atmosphere in which a hydrogen gas and a carrier gas (e.g., argon gas (Ar), nitrogen gas (N₂), etc.) are mixed, the heat treatment may be performed at a temperature higher than room temperature (e.g., 400 to 600°C) to inject hydrogen. In addition, hydrogen may be injected using hydrogen plasma or the like. The hydrogen may be injected into the second semiconductor layer 126 by various other methods.

In the present embodiment, before the first portion forming step ST16 of forming the first semiconductor layer 124 including the amorphous portion, the first photovoltaic part forming step ST30 of forming the first photovoltaic part 110 containing the perovskite compound, and the electrode forming step ST40, the hydrogen injecting step ST14 is performed. As such, after performing the hydrogen injecting step ST14 performed in a higher process than the first portion forming step ST16 and the first photovoltaic part forming step ST30, the first semiconductor layer 124 and the first photovoltaic part 110 are formed, so it is possible to prevent the change in properties, the damage, or the like of the first semiconductor layer 124 and the first photovoltaic part 110 from occurring due to the high temperature in the hydrogen injecting step ST14. However, the present disclosure is not limited thereto, and the order of the hydrogen injecting step ST14 or the like may be variously modified.

Then, as illustrated in FIG. 9C, in the first portion forming step ST14, the first intermediate film 124a and/or the first semiconductor layer 124 is formed on the one side (e.g., the front side) of the semiconductor substrate 122.

More specifically, the first intermediate film 124a and the first semiconductor layer 124 may be entirely formed on the other side of the semiconductor substrate 122. In this case, since the first intermediate film 124a and the first semiconductor layer 124 are formed using a single-sided deposition process, a separate etching process or the like may not be performed. However, the present disclosure is not limited thereto, and various modifications are possible, such as forming the first intermediate film 124a and the first semiconductor layer 124 by a double-sided deposition process and removing a portion of the first intermediate film 124a and the first semiconductor layer 124.

For example, the first intermediate film 124a and/or the first semiconductor layer 124 may be formed by the vapor deposition method (e.g., chemical vapor deposition (CVD), for example, plasma-induced chemical vapor deposition (PECVD)) or the like. In the present embodiment, the first semiconductor layer 124 may include an amorphous portion composed of a semiconductor material including a first conductive dopant. The first semiconductor layer 124 is formed by being deposited with a first conductive dopant, and may be additionally subjected to an activation heat treatment or the like, and may be formed by depositing an intrinsic semiconductor material to form a semiconductor layer and then doping the first conductive dopant by a doping process.

As an example, the first intermediate film 124a and the first semiconductor layer 124 may be sequentially formed on the front side of the semiconductor substrate 122 using an in-situ process for changing the type of gas used in a continuous process within the same equipment. For example, in a plasma-induced chemical vapor deposition apparatus, the first intermediate film 124a may be formed by the chemical vapor deposition at a temperature of 150°C to 200°C and a pressure lower than normal pressure (e.g., 10 torr or less), and under a gas atmosphere including a silicon-containing gas (e.g., silane (SiH₄)), hydrogen gas (H₂), etc., and then the first semiconductor layer 124 may be formed by the chemical vapor deposition by additionally supplying a dopant-containing gas (e.g., PH₃, BBr₃, etc.) including the first conductive dopant. As a result, it is possible to easily form the first intermediate film 124a and the first semiconductor layer 124 by a simple process. However, the present disclosure is not limited thereto, and the first intermediate film 124a and the first semiconductor layer 124 may be formed by various methods.

In this case, since the first intermediate film 124a and/or the first semiconductor layer 124 includes an amorphous portion and is formed at a relatively low temperature, in the deposition process for the first portion forming step ST16, the hydrogen may be sufficiently injected into the first intermediate film 124a and/or the first semiconductor layer 124. That is, the first portion forming step ST16 may include a process of injecting hydrogen into the first intermediate film 124a and/or the first semiconductor layer 124. Accordingly, since it is not necessary to separately perform a process of injecting hydrogen into the first intermediate film 124a and/or the first semiconductor layer 124, the process may be simplified.

Here, the process temperature of the process of forming the first semiconductor layer 124 may be lower than the process temperature of the process of forming the second semiconductor layer 126. This is to facilitate the formation of the second semiconductor layer 126 including the polycrystalline portion while preventing the change in properties, the deterioration, or the like of the first semiconductor layer 124 including the amorphous portion. In addition, the process pressure of the process of forming the first semiconductor layer 126 may be greater than the process pressure of the process of forming the second semiconductor layer 126. This is to allow the second semiconductor layer 126 including the polycrystalline portion to be stably formed.

In the present embodiment, the first semiconductor layer 124 is formed after the second semiconductor layer 126 is first formed. This is because the process temperature of the process of forming the second semiconductor layer 126 is higher than that of the process of forming the first semiconductor layer 124, and thus, when the process of forming the second semiconductor layer 126 after forming the first semiconductor layer 124 including the amorphous portion is performed, the change in properties, the deterioration, or the like of the first semiconductor layer 124 may occur due to the process of forming the second semiconductor layer 126. However, the present disclosure is not limited thereto, and the formation order of the second intermediate film 126a, the second semiconductor layer 126, the first intermediate film 124a, and the first semiconductor layer 124 may be different.

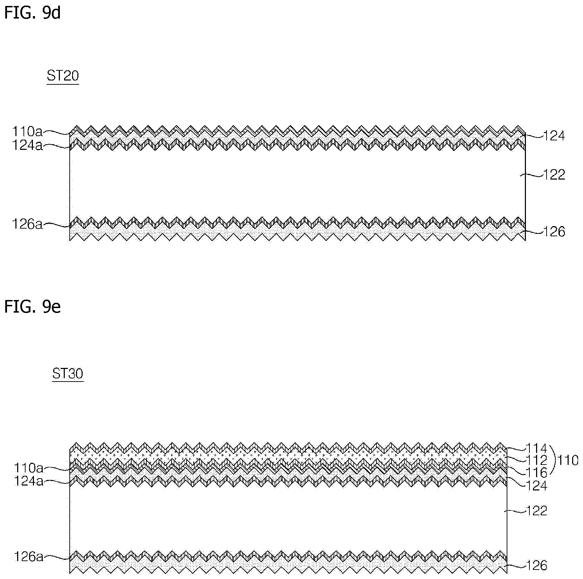

Subsequently, as illustrated in FIG. 9D, in the junction layer forming step ST20, the junction layer 110a is formed on the second photovoltaic part 120. More specifically, the junction layer 110a may be formed on the first semiconductor layer 124 of the second photovoltaic part 120. The junction layer 110a may be formed by, for example, a vacuum deposition process (evaporation) or a sputtering process. The vacuum deposition process or the sputtering process may be performed at a low temperature, and the junction layer 110a may be formed only on the second semiconductor layer 124 as a cross-sectional process. However, the present disclosure is not limited thereto, and various methods such as a coating method and a deposition method may be applied.

Subsequently, as illustrated in FIG. 9D, in the step ST30 of forming the first photovoltaic part 110, the first photovoltaic part 110 is formed on the junction layer 110a. More specifically, the second transport layer 116, the photovoltaic layer 112, and the first transport layer 114 may be sequentially formed on the junction layer 110a.

The second transport layer 116, the photovoltaic layer 112, and the first transport layer 114 may be formed by various methods, and may be formed by, for example, deposition (e.g., physical vapor deposition, chemical vapor deposition, etc.), a printing method, or the like. Here, the printing method may include inkjet printing, gravure printing, spray coating, doctor blade, bar coating, gravure coating, brush painting, slot-die coating, and the like. However, the present disclosure is not limited thereto.

Subsequently, as illustrated in FIG. 9E, in the electrode forming step ST40, the first electrode 42 and the second electrode 44 may be formed.

That is, the first electrode layer 420 of the first electrode 42 may be formed on the first photovoltaic part 110 (more specifically, the first transport layer 114), and the second electrode layer 422 may be formed on the first electrode layer 420. In addition, the metal electrode layer 442 of the second electrode 44 may be formed on the second photovoltaic part 120 (more specifically, the second semiconductor layer 126 including the polycrystalline portion).

The first electrode layer 420 of the first electrode 42 may be formed by, for example, the vacuum deposition process or the sputtering process. The vacuum deposition process or the sputtering process may be performed at a low temperature, and the first electrode layer 420 of the first electrode 42 may be formed only on the front side, which is a cross-section. However, the present disclosure is not limited thereto, and various methods such as a coating method may be applied. In addition, in the present embodiment, the second electrode layer 422 of the first electrode 42 and the metal electrode layer 442 of the second electrode 44 may be formed. For example, the second electrode layer 422 of the first electrode 42 and the metal electrode layer 442 of the second electrode 44 may be formed by applying a low-temperature firing paste containing a metal and a resin and performing curing heat treatment for curing the low-temperature firing paste.

For example, after forming the first electrode layer 420 of the first electrode 42, the low-temperature firing paste for the second electrode layer 422 of the first electrode 42 and the metal electrode layer 442 of the second electrode 44 may be applied and the curing heat treatment for simultaneously curing the low-temperature firing paste for the second electrode layer 422 of the first electrode 42 and the metal electrode layer 442 of the second electrode 44 may be performed. The curing heat treatment may be performed at a low temperature of 150°C or lower to prevent the change in properties, the deterioration, or the like of the first photovoltaic part 110 containing the perovskite compound.

The order of the process of forming the first electrode layer 420 of the first electrode 42, the coating process and heat treatment process of the second electrode layer 422 of the first electrode 42, and the coating process and heat treatment process of the metal electrode layer 442 of the second electrode 44 may be variously modified. That is, in the present embodiment, it is exemplified that the first electrode 42 and the second electrode 44 are formed by performing the electrode forming step ST40 after the second photovoltaic part forming step ST10 and the first photovoltaic part forming step ST30, but the present disclosure is not limited thereto. Accordingly, various modifications such as forming at least a portion of the second electrode 44 before the first photovoltaic part forming step ST30 are possible.

In addition, the above description exemplifies that the second electrode layer 422 of the first electrode 42 and the metal electrode layer 442 of the second electrode 44 are formed by the printing method to simplify the process. However, the present disclosure is not limited thereto, and the method and process conditions of forming the second electrode layer 422 of the first electrode 42 and the metal electrode layer 442 of the second electrode 44 may be variously modified.

According to the present embodiment, it is possible to improve productivity by forming a solar cell having a tandem structure having excellent efficiency through a simple fabricating process. In this case, it is possible to effectively prevent the deterioration in properties or the like of the first semiconductor layer 124 including the amorphous portion or the first photovoltaic part 110 containing the perovskite compound by maintaining the process temperature of the electrode forming step ST40 or the like performed after the first photovoltaic part forming step ST30 of forming the first photovoltaic part forming the first photovoltaic part 110 containing the perovskite compound at a low temperature (e.g., 150°C or lower).

In the present embodiment, the uneven or anti-reflection structure by the texturing is provided on the front side of the semiconductor substrate 122 to perform the anti-reflection role, so the anti-reflection film is not provided on the front side of the solar cell 100. In this case, the uneven or anti-reflection structure corresponding to the uneven or anti-reflection structure formed on the front side of the semiconductor substrate 122 may be formed as it is on the first intermediate film 124a positioned on the front side of the semiconductor substrate 122, the first semiconductor layer 124, the second transport layer 116, the photovoltaic layer 112, the first transport layer 114, and both surfaces of the first electrode layer 420. As such, since a separate anti-reflection structure is not provided, the structure may be simplified. However, the present disclosure is not limited thereto, and the anti-reflection film may be further provided on at least a portion of the first electrode layer 420 of the first electrode 42 as illustrated in FIG. 10. Various other modifications are possible.

In addition, in the present embodiment, a simple structure is exemplified because a separate passivation film is not provided on the second semiconductor layer 126. This is because the second semiconductor layer 126 may contain hydrogen in a sufficient amount by the hydrogen injection step ST14 and have excellent passivation characteristics, and thus, the effect obtained by leaving the passivation film may not be large. However, the present disclosure is not limited thereto, and as illustrated in FIG. 12, various modifications such as a passivation film remaining on at least a portion of the second semiconductor layer 126 or forming a separate passivation film are possible.

Hereinafter, a solar cell and a method of fabricating the same according to another embodiment of the present disclosure will be described in detail. A detailed description of the same or extremely similar parts as or to the above description will be omitted and only different parts will be described in detail. The above-described embodiment or a modified example thereof and a combination of the following embodiment or the modified examples thereof also falls within the scope of the present disclosure.

FIG. 10 is a cross-sectional view schematically illustrating a solar cell according to another embodiment of the present disclosure. FIG. 10 is a cross-sectional view taken along line X-X of FIG. 2.

Referring to FIG. 10, in the solar cell 100 according to the present embodiment, the uneven or anti-reflection structure is not provided on one side (e.g., a front side) of the semiconductor substrate 122. That is, one side of the semiconductor substrate 122 may be provided as a flat surface having a smaller surface roughness than the other side of the semiconductor substrate 122. Accordingly, the first intermediate film 124a positioned on one side of the semiconductor substrate 122, the first semiconductor layer 124, the second transport layer 116, the photovoltaic layer 112, the first transport layer 114, and both surfaces of the firs electrode layer 420 may also be provided as a flat surface having a smaller surface roughness than the other side of the semiconductor substrate 122.

In this case, the anti-reflection film 118 for preventing reflection may be further provided on the first electrode layer 420. For example, FIG. 10 illustrates that only the bus bar electrode 42b to which a wiring material, an interconnector, a ribbon, etc. for connection with another solar cell 100 or an external circuit is attached is exposed in the second electrode layer 422. Accordingly, the anti-reflection film 118 has an opening exposing the bus bar electrode 42b on the first electrode layer 420 and in the second electrode layer 422, and may be formed while entirely covering the portion where other portions (that is, the finger electrode 42a and the second electrode layer 422) are formed. Accordingly, by maximizing a formation area of the anti-reflection film 118, it is possible to improve the anti-reflection characteristics. After forming the first electrode layer 420 and the second electrode layer 422 to form the anti-reflection film 118, the anti-reflection film 118 may be deposited or vacuum deposited while a mask having an opening exposing the bus bar electrode 42b is positioned.

However, the present disclosure is not limited thereto, and the anti-reflection film 118 may be formed on the first electrode layer 420 to correspond to a portion where the second electrode layer 422 is not formed, that is, to expose the bus bar electrode 42b and the finger electrode 42a. Various other modifications are possible.

For example, the anti-reflection film 118 may have a single layer of any one or a multilayer structure, in which two or more films are combined, selected from the group consisting of a silicon nitride film, a silicon nitride film containing hydrogen, a silicon oxide film, a silicon oxynitride film, an aluminum oxide film, a silicon carbide film, MgF₂, ZnS, TiO₂, and CeO₂ For example, the anti-reflection film 118 may include MgF₂ to maximize the anti-reflection effect in the solar cell 100 having a tandem structure containing a perovskite compound. However, the present disclosure is not limited thereto.

FIG. 10 illustrates that the anti-reflection film 118 is provided on the first electrode layer 420 when the front side of the semiconductor substrate 122 is formed as a flat surface. However, the present disclosure is not limited thereto. Accordingly, as illustrated in FIG. 1, when the uneven or anti-reflection structure is provided on the front side of the semiconductor substrate 122, the anti-reflection film 118 is additionally formed on the first electrode layer 420 to improve the anti-reflection effect. Various other modifications are possible.

FIG. 11 is a cross-sectional view schematically illustrating a solar cell according to another embodiment of the present disclosure.

Referring to FIG. 11, an optical layer 128 may be further provided on the second semiconductor layer 126. The optical film 128 may perform various roles, such as a reflective film for inducing reflection of internal light and an anti-reflection film for preventing reflection of external light. For example, in a double-sided light-receiving type solar cell in which the second electrode layer 422 has a predetermined pattern and light receives from both sides, the optical film 128 may be formed on the second semiconductor layer 126 to maximize the amount of light incident into the solar cell 100. However, the present disclosure is not limited thereto, and the optical film 128 may be provided on the second semiconductor layer 126 even in a single-sided light-receiving type solar cell.

In FIG. 11, the optical film 118 may be formed in various steps and by various methods. That is, the hydrogen injection layer 126b formed to inject hydrogen into the second semiconductor layer 116 in FIG. 9B may remain and be used as the optical film 118. In this case, before the process of forming the second electrode 44, the opening through which the second electrode 44 passes may be formed in the optical film 118 by using laser ablation or the like. Alternatively, a separate insulating film may be formed before or after the process of forming the second electrode 44 and used as the optical film 118. In this case, in the optical film 118, an opening for penetrating through the second electrode 44, an opening for connecting the second electrode 44 to the wiring material, the interconnector, the ribbon, etc., may be formed during the process of forming the optical film 118 or after the process of forming the optical film 118.

For example, the optical film 128 may have a single layer of any one or a multilayer structure in which two or more films are combined, selected from the group consisting of a silicon nitride film, a silicon nitride film containing hydrogen, a silicon oxide film, a silicon oxynitride film, an aluminum oxide film, a silicon carbide film, MgF₂, ZnS, TiO₂, and CeO₂ For example, the optical layer 128 may include a silicon nitride layer to maximize the anti-reflection effect in the first photovoltaic part 110 including the semiconductor substrate 122. However, the present disclosure is not limited thereto.

FIG. 11 illustrates that the uneven or anti-reflection structure is not provided on the other side (e.g., the rear side) of the semiconductor substrate 122. That is, the other side of the semiconductor substrate 122 may be provided as a flat surface having a smaller surface roughness than one side of the semiconductor substrate 122. Accordingly, the second intermediate film 126a positioned on one side of the semiconductor substrate 122 and both surfaces of the second semiconductor layer 126 may also be provided as a flat surface having a smaller surface roughness than the other side of the semiconductor substrate 122. As described above, FIG. 11 illustrates that the optical film 128 is provided on the second semiconductor layer 126 when the other side of the semiconductor substrate 122 is formed as a flat surface. However, the present disclosure is not limited thereto. Accordingly, as illustrated in FIG. 1, when the uneven or anti-reflection structure is provided on the front side of the semiconductor substrate 122, the optical film 128 may be additionally formed on the second semiconductor layer 126 to further improve the light-receiving characteristics. In this case, the optical film 128 may entirely expose the metal electrode layer 442 of the second electrode 44 on the second semiconductor layer 126, or may cover a portion (for example, a finger electrode) of the metal electrode layer 442 of the second electrode 44 and expose (e.g., a bus bar electrode) thereof. Various other modifications are possible.

Figure 12 is a front plan view illustrating a solar cell according to another embodiment of the present disclosure. For clear understanding, an illustration of a first electrode layer of a first electrode is omitted in FIG. 12, and a second electrode layer is mainly illustrated.

Referring to FIG. 12, 6 to 33 (e.g., 8 to 33, for example 10 to 33, and particularly, 10 to 15) first electrode layers 422 of the first electrode 42 are provided on one side of the semiconductor substrate 122 in a direction (y-axis direction of the drawing) crossing an extending direction of the bus bar electrodes 42b, respectively, and a plurality of bus bar electrodes 42b may be positioned at a uniform distance from each other. Here, the bus bar electrode 42b has a relatively wide width, includes a plurality of pad parts 422b in a longitudinal direction, and may further include a line part 421b connecting the plurality of pad parts 422b in the longitudinal direction. In addition, the first electrode 42 may further include an edge line 42c, an edge electrode part 42d, and the like. Although the first electrode 42 is mainly illustrated in FIG. 12 and the above description, the metal electrode layer 442 of the second electrode 44 may have the same or similar shape. The edge line 42c and the edge electrode part 42d may or may not be provided, and the shape, arrangement, or the like thereof may be variously modified.

The solar cell 100 having the bus bar electrode 42b having such a shape may be connected to the neighboring solar cell 100 or an external circuit using a wire-shaped wiring material (interconnector). The wire-shaped wiring material may have a smaller width than a ribbon having a relatively wide width (e.g., greater than 1 mm). For example, the maximum width of the wiring member may be 1 mm or less (e.g., 500 µm or less, and more specifically, 250 to 500 µm).

Such a wiring material may have a structure including a core layer and a solder layer formed on a surface thereof. Then, a large number of wiring materials may be effectively attached by a process of applying heat and pressure while the plurality of wiring materials are mounted on the solar cell 100. The wiring material or the core layer included therein may include a rounded portion. That is, the cross section of the wiring material or the core layer may include a portion in which at least a portion is circular, or a portion of a circle, an ellipse, or a portion of an ellipse, or a curved portion.

Then, it is possible to reduce the moving distance of the carrier by a large number of wiring materials while minimizing light loss and material cost by the wiring material having a small width. As described above, it is possible to improve the efficiency of the solar cell 100 by reducing the moving distance of the carrier while reducing the light loss, and it is possible to reduce the material cost of the wiring material.

In addition, the structures, shapes, and arrangements of the first and second electrodes 42 and 44 and the structures, shapes, and the like of the wiring material, the interconnector, the ribbon, etc., connected thereto may be variously modified.

Features, structures, effects, etc., according to the above description are included in at least one embodiment of the present disclosure, and are not necessarily limited only to one embodiment. Furthermore, features, structures, effects, etc., illustrated in each embodiment can be practiced by being combined or modified for other embodiments by those of ordinary skill in the art to which the embodiments pertain. Accordingly, the contents related to such combinations and modifications should be interpreted as being included in the scope of the present disclosure.

## Claims

1. A solar cell, comprising:
a photovoltaic part including a first photovoltaic part that includes a photovoltaic layer composed of a perovskite compound and a second photovoltaic part that includes a semiconductor substrate;
a first electrode electrically connected to the photovoltaic part on one side of the photovoltaic part; and
a second electrode electrically connected to the photovoltaic part on the other side of the photovoltaic part,
wherein the second photovoltaic part includes the semiconductor substrate, a first semiconductor layer that is formed separately from the semiconductor substrate on one side of the semiconductor substrate, and a second semiconductor layer that is formed separately from the semiconductor substrate on the other side of the semiconductor substrate and has a crystal structure different from that of the first semiconductor layer.

2. The solar cell of claim 1, wherein the first semiconductor layer positioned on a front side of the semiconductor substrate includes an amorphous portion, and
the second semiconductor layer positioned on a rear side of the semiconductor substrate includes a polycrystalline portion.

3. The solar cell of claim 1, wherein in the second photovoltaic part, the first semiconductor layer positioned adjacent to the first photovoltaic part includes an amorphous portion, and
in the second photovoltaic part, the second semiconductor layer positioned on a surface opposite to the first photovoltaic part includes a polycrystalline portion.

4. The solar cell of claim 3, wherein a thickness of the second semiconductor layer is greater than that of the first semiconductor layer.

5. The solar cell of claim 1, wherein the first semiconductor layer includes an amorphous portion,
the second semiconductor layer includes a polycrystalline portion, and
a hydrogen content of the first semiconductor layer is greater than that of the second semiconductor layer.

6. The solar cell of claim 1, further comprising:
a first intermediate film positioned between the semiconductor substrate and the first semiconductor layer and a second intermediate film positioned between the semiconductor substrate and a second conductive region,
wherein materials or thicknesses of the first interlayer and the second interlayer are different from each other.

7. The solar cell of claim 6, wherein the semiconductor substrate and the first semiconductor layer have a hetero-junction structure having different crystal structures with the first intermediate layer composed of a semiconductor material therebetween, and
the semiconductor substrate and the second semiconductor layer have an insulating junction structure or a tunnel-junction structure in which the semiconductor substrate and the second semiconductor layer are bonded to each other with the second intermediate layer composed of an insulating material therebetween.

8. The solar cell of claim 6, wherein the first semiconductor layer includes an amorphous portion,
the second semiconductor layer includes a polycrystalline portion,
the first intermediate film includes a semiconductor material, and
the second intermediate film contains an insulating material.

9. The solar cell of claim 8, wherein the first intermediate film contains intrinsic amorphous silicon, and
the second intermediate film contains silicon oxide.

10. The solar cell of claim 8, wherein a thickness of the second intermediate film is smaller than that of the first intermediate film.

11. The solar cell of claim 8, wherein a hydrogen content of the first intermediate film is greater than a hydrogen content of the second intermediate film.

12. The solar cell of claim 1, wherein the first photovoltaic part is positioned on one side of the second photovoltaic part,
the first electrode is positioned on the first photovoltaic part,
the second electrode is positioned on the second semiconductor layer of the second photovoltaic part,
the second semiconductor layer includes a polycrystalline portion, and
a stacked structure of the first electrode and the second electrode are different from each other.

13. The solar cell of claim 12, wherein the first electrode includes a first electrode layer that is formed on the first photovoltaic part and contains a transparent conductive material, and a second electrode layer that is formed on the first electrode layer and contains a metal, and
the second electrode layer includes a metal electrode layer that is formed on the second electrode layer and contains a metal.

14. The solar cell of claim 12, further comprising:
at least one of an anti-reflection film formed on the first electrode layer and an optical film formed on the second semiconductor layer.

15. A method of fabricating a solar cell, comprising:
forming a second photovoltaic part including a semiconductor substrate, a first semiconductor layer that is formed separately from the semiconductor substrate on one side of the semiconductor substrate, and a second semiconductor layer that is formed separately from the semiconductor substrate on the other side of the semiconductor substrate and has a crystal structure different from that of the first semiconductor layer;
forming a first photovoltaic part including a photovoltaic layer composed of a perovskite compound on the first semiconductor layer; and
forming a first electrode electrically connected to the first photovoltaic part on one side of the first photovoltaic part and a second electrode electrically connected to the second photovoltaic part on the other side of the second photovoltaic part.

16. The method of claim 15, wherein the forming of the second photovoltaic part includes:
forming a second portion including the second semiconductor layer including a polycrystalline portion on the other side of the semiconductor substrate; and
forming a first portion including the first semiconductor layer including an amorphous portion on the one side of the semiconductor substrate.

17. The method of claim 16, further comprising:
injecting hydrogen into the second semiconductor layer between the forming of the second portion and the forming of the first portion,
wherein in the forming of the first portion, a process of injecting the hydrogen into the first semiconductor layer is performed together.

18. The method of claim 16, wherein a temperature of a process of forming the first semiconductor layer is lower than that of a process of forming the second semiconductor layer, and
a pressure of the process of forming the first semiconductor layer is higher than that of the process of forming the second semiconductor layer.

19. The method of claim 16, wherein in the forming of the second portion, the second portion formed on the one side is removed to form the second portion on the other side after forming the second portion on both sides of the semiconductor substrate by a double-sided deposition process, and
in the forming of the first portion, the first portion is formed on the one side of the semiconductor substrate by a single-sided deposition process.

20. The method of claim 16, wherein the forming of the second portion further includes a process of forming a second intermediate film before a process of forming the second semiconductor layer,
the forming of the first portion further includes a process of forming a first intermediate film before a process of forming the first semiconductor layer,
the process of forming the second intermediate film and the process of forming the second semiconductor layer are formed by a continuous process, and
the process of forming the first intermediate film and the process of forming the first semiconductor layer are formed by the continuous process.
